(19) Europäisches Patentamt
European Patent Office
Office européen des brevets

(11) **EP 4 152 710 B1**

(12) **EUROPEAN PATENT SPECIFICATION**

(45) Date of publication and mention
of the grant of the patent:
**25.02.2026  Bulletin 2026/09**

(21) Application number: **21817857.2**

(22) Date of filing: **31.05.2021**

(51) International Patent Classification (IPC):
*H04L 1/00* (2006.01)      *H03M 13/25* (2006.01)
*H03M 13/27* (2006.01)      *H04L 27/00* (2006.01)
*H04L 27/34* (2006.01)      *H04L 27/18* (2006.01)
*H04L 27/26* (2006.01)      *H04L 5/00* (2006.01)

(52) Cooperative Patent Classification (CPC):
**H03M 13/255; H03M 13/2789; H03M 13/2792;
H04L 1/0042; H04L 1/0071; H04L 27/0008;
H04L 27/18; H04L 27/2604; H04L 27/2634;
H04L 27/34;** H04L 1/0058; H04L 1/0059

(86) International application number:
**PCT/CN2021/097485**

(87) International publication number:
**WO 2021/244497 (09.12.2021 Gazette 2021/49)**

(54) **INTERLEAVING AND SUBCARRIER MAPPING METHOD SUPPORTING UNEQUAL
MODULATION, AND RELATED DEVICE**

VERSCHACHTELUNGS- UND SUBTRÄGERABBILDUNGSVERFAHREN MIT UNTERSTÜTZUNG
UNGLEICHER MODULATION UND ZUGEHÖRIGE VORRICHTUNG

PROCÉDÉ D'ENTRELACEMENT ET DE MISE EN CORRESPONDANCE DE SOUS-PORTEUSES
PRENANT EN CHARGE UNE MODULATION INÉGALE, ET DISPOSITIF ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **02.06.2020  CN 202010490950**

(43) Date of publication of application:
**22.03.2023  Bulletin 2023/12**

(73) Proprietor: **Huawei Technologies Co., Ltd.
Longgang District,
Shenzhen,
Guangdong 518129 (CN)**

(72) Inventors:
• **HU, Mengshi
 Shenzhen, Guangdong 518129 (CN)**
• **YU, Jian
 Shenzhen, Guangdong 518129 (CN)**
• **GAN, Ming
 Shenzhen, Guangdong 518129 (CN)**
• **LIN, Wei
 Shenzhen, Guangdong 518129 (CN)**

(74) Representative: **Pfenning, Meinig & Partner mbB
Patent- und Rechtsanwälte
Theresienhöhe 11a
80339 München (DE)**

(56) References cited:
**CN-A- 101 064 708      CN-A- 101 778 394
CN-B- 106 922 212      US-A1- 2007 019 747
US-A1- 2015 121 176      US-B2- 10 536 196
US-B2- 8 605 664**

• **NTT DOCOMO: "Modified Multistage InterLeaver
(MIL) for channel interleaving", TSG-RAN
WORKING GROUP1 MEETING #5 TSGR1#5(99)
662 R1-99662, 10 June 1999 (1999-06-10),
XP050088879**
• **NOKIA, NOKIA SHANGHAI BELL: "Bit-
interleaving for LDPC", 3GPP TSG RAN WG1
MEETING NR#3 R1-1716556, 21 September 2017
(2017-09-21), XP051340009**

**Description**

**TECHNICAL FIELD**

This application relates to the field of communication technologies, and in particular, to two interleaving methods supporting unequal modulation, and related apparatuses, computer-readable storage mediums, and computer program products.

**BACKGROUND**

A modern wireless communication service imposes ever-increasing requirements on a channel capacity and communication performance of a communication system. To improve a channel capacity and communication performance of a wireless communication system, a plurality of resource units (resource unit, RU) are allowed to be allocated to a same user in the Institute of Electrical and Electronics Engineers (Institute of Electrical and Electronics Engineers, IEEE) 802.11be protocol standard. To further improve allocation flexibility and spectrum usage of the wireless communication system, when a plurality of RUs may be allocated to one user, different modulation and coding schemes (Modulation and Coding Scheme, MCS) may be configured for the plurality of RUs of the same user. In other words, the plurality of RUs support unequal modulation (Unequal Modulation, UEQM).

In a wireless local area network (Wireless Local Area Network, WLAN) communication system, if a BCC coding manner is used, an interleaver interleaves information bits of RUs. Currently, one interleaver only processes an RU using only one modulation scheme. Information bits of each of a plurality of RUs are interleaved by using a single interleaver, to process information bits of the plurality of RUs using different MCSs. How to improve an information processing capability of an interleaver is an urgent problem to be resolved by a person skilled in the art.

United States patent US 10 536 196 B2 discloses systems, methods, and instrumentalities for multiple resource unit (RU) allcation for OFDMA WLAN. A transmitter may parse an encoded bit stream into a plurality of spatial steams. The transmitter may determine an allocation of encoded bits of the plurality of spatial steams to a plurality of interleavers. The transmitter may allocate the encoded bits to the plurality of interleavers based on the determined allocation. The allocation of the encoded bits may be determined based on one or more of channel related feedback, an RU configuration associated with the transmission, a quanlity of service (QoS), and/or traffic priorities. The transmitter may interleave the encoded bits using the plurality of interleavers. The transmitter may combine the interleaved encoded bits from the plurality of interleavers into a sequenced bit stream.

Chinese patent CN 106 922 212 B provides an interleaving processing method and apparatus in a WLAN system, wherein the apparatus comprises: a bit distribution unit, which is used for allocating bits of an encoded data stream to n sub-resource block interleaving units in sequence, n being an positive integer greater than 1, and the number of n being the number of resource blocks allocated for the user; the sub-resource block interleaving units, which are used for discretely interleaving entered bits. With the above apparatus and method, the system performance can be improved.

United States patent US 8 605 664 B2 discloses a method and a system for transmitting data by a transmitter over a channel having a predetermined channel quality estimate.

**SUMMARY**

This application provides two interleaving methods supporting unequal modulation, and related apparatuses, computer-readable storage mdiums, and computer program products, to enable a unified interleaver to interleave information bits of a plurality of RUs using different modulation and coding schemes, or enable a unified subcarrier mapper to map subcarriers of a plurality of RUs using different modulation and coding schemes. The invention is defined by the appended claims.

According to a first aspect, this application provides an interleaver supporting unequal modulation. The interleaver includes a first interleaver and a second interleaver, the interleaver is configured to interleave information bits, to determine an order of information bits carried in a subcarrier of a first RU and a subcarrier of a second RU, and a modulation scheme of the first RU is different from a modulation scheme of the second RU. The first interleaver is configured to input information bits by row. A quantity of columns of the first interleaver is $M_1+M_2$, a quantity of rows of the first interleaver is a larger value in $N_1$ and $N_2$, $N_1$ is a quantity of rows determined based on a quantity of subcarriers of the first RU, $M_1$ is a quantity of columns determined based on the quantity of subcarriers of the first RU, $N_2$ is a quantity of rows determined based on a quantity of subcarriers of the second RU, $M_2$ is a quantity of columns determined based on the quantity of subcarriers of the second RU, and $N_1$, $M_1$, $N_2$, and $M_2$ are positive integers. The second interleaver is configured to receive the information bits that are output by the first interleaver by column, and perform interleaving mapping on the information bits. The interleaver can interleave information bits of a plurality of RUs using different modulation and coding schemes, to simplify a hardware structure of a communication apparatus, and reduce hardware costs.

With reference to the first aspect, in a possible implementation, the first interleaver is configured to input information bits of a first unit and information bits of a second unit by row. A quantity of columns of valid information bits of the first unit is $M_1+M_>$, a quantity of rows of the valid information bits of the first unit is a smaller value in $N_1$ and $N_2$, and the valid information bits are bits including an information amount. A quantity of columns of valid information bits of the second unit is $M_1$ or $M_2$, and a quantity of rows of the valid information bits of the second unit is an absolute value of a difference between $N_1$ and $N_2$. A first row of the information bits of the second unit is an $(N_2+1)^{th}$ row of the first interleaver, and a first column of the information bits of the second unit is a first column of the interleaver; or a first row of the information bits of the second unit is an $(N_1+1)^{th}$ row of the first interleaver, and a first column of the information bits of the second unit is an $(M_1+1)^{th}$ column of the first interleaver.

With reference to the first aspect, in a possible implementation, the second interleaver is configured to perform interleaving mapping on information bits of a third unit and information bits of a fourth unit. Specifically, the second interleaver is configured to perform interleaving mapping on valid information bits of the third unit based on a modulation order of the first RU, a quantity of columns of the valid information bits of the third unit is $M_1$, a quantity of rows of the valid information bits of the third unit is $N_1$, and the valid information bits are bits including an information amount. The second interleaver is configured to perform interleaving mapping on valid information bits of the fourth unit based on a modulation order of the second RU, a quantity of columns of the valid information bits of the fourth unit is $M_2$, and a quantity of rows of the valid information bits of the fourth unit is $N_2$. A first column of the information bits of the fourth unit is an $(M_1+1)^{th}$ column of the second interleaver.

With reference to the first aspect, in a possible implementation, there is only one spatial data stream on the first RU and the second RU, the second interleaver is connected to a bit parser, after being processed by the bit parser, valid information bits output by the second interleaver by column are carried on the subcarrier of the first RU and the subcarrier of the second RU, and the valid information bits are bits including an information amount.

With reference to the first aspect, in a possible implementation, there are at least two spatial data streams on the first RU and the second RU, the interleaver further includes a third interleaver, and the third interleaver is connected to the second interleaver and a bit parser. The third interleaver is configured to receive valid information bits output by the second interleaver by column, and perform frequency rotation on a spatial data stream other than a first spatial data stream in the at least two spatial data streams, the first spatial data stream is one of the at least two spatial data streams, and the valid information bits are bits including an information amount. After being processed by the bit parser, valid information bits output by the third interleaver by column are carried on the subcarrier of the first RU and the subcarrier of the second RU.

It should be noted that the first interleaver, the second interleaver, and the third interleaver may include a hardware structure and a software module, and implement the functions in a form of the hardware structure, the software module, or a combination of the hardware structure and the software module. A function in the foregoing functions may be performed in a form of the hardware structure, the software module, or both the hardware structure and the software module.

According to a second aspect, this application provides an interleaver supporting unequal modulation. The interleaver includes a first interleaver and a second interleaver, the interleaver is configured to interleave information bits, to determine an order of information bits carried in a subcarrier of a first RU and a subcarrier of a second RU, and a modulation scheme of the first RU is different from a modulation scheme of the second RU. The first interleaver is configured to input information bits by row. A quantity of rows of the first interleaver is i $\times$ (n + m), a quantity of columns of the first interleaver is j/i, i is a positive integer, n is a modulation order of the first RU, m is a modulation order of the second RU, and j is a larger value in a quantity of subcarriers of the first RU and a quantity of subcarriers of the second RU. The second interleaver is configured to receive the information bits that are output by the first interleaver by column, and perform interleaving mapping on the information bits. The interleaver can interleave information bits of a plurality of RUs using different modulation and coding schemes, to simplify a hardware structure of a communication apparatus, and reduce hardware costs.

With reference to the second aspect, in a possible implementation, the first interleaver is configured to input information bits of i first units and information bits of i second units by row. A quantity of columns of valid information bits of the first unit is less than or equal to the quantity of columns of the first interleaver, a total quantity of rows of valid information bits of the i first units is n $\times$ i, and the valid information bits are bits including an information amount. A quantity of columns of valid information bits of the second unit is less than or equal to the quantity of columns of the first interleaver, and a total quantity of rows of valid information bits of the i second units is m $\times$ i. A quantity of rows of the first interleaver corresponding to a first row of information bits of an $a^{th}$ first unit is (a - 1) $\times$ n + (a - 1) $\times$ m + 1, and a is a positive integer less than or equal to i. A quantity of rows of the first interleaver corresponding to a first row of information bits of a $b^{th}$ second unit is b $\times$ n + (b - 1) $\times$ m + 1, and b is a positive integer less than or equal to i.

With reference to the second aspect, in a possible implementation, the second interleaver is configured to perform interleaving mapping on information bits of i third units and information bits of i fourth units. Specifically, the second interleaver is configured to perform interleaving mapping on valid information bits of the third unit based on the modulation order of the first RU, a quantity of columns of the valid information bits of the third unit is less than or equal to the quantity of columns of the first interleaver, a total quantity of rows of valid information bits of the i third units is $n \times i$, and the valid information bits are bits including an information amount. The second interleaver is configured to perform interleaving mapping on valid information bits of the fourth unit based on the modulation order of the second RU, a quantity of columns of the valid information bits of the fourth unit is less than or equal to the quantity of columns of the first interleaver, and a total quantity of rows of valid information bits of the i fourth units is $m \times i$. A quantity of rows of the second interleaver corresponding to a first row of information bits of a $c^{th}$ third unit is $(c - 1) \times n + (c - 1) \times m + 1$, and c is a positive integer less than or equal to i. A quantity of rows of the second interleaver corresponding to a first row of information bits of a $d^{th}$ fourth unit is $d \times n + (d - 1) \times m + 1$, and d is a positive integer less than or equal to i.

With reference to the second aspect, in a possible implementation, there is only one spatial data stream on the first RU and the second RU, and the second interleaver is connected to a bit parser. After being processed by the bit parser, valid information bits output by the second interleaver by column are sequentially output as first information bits in a unit of n bits and second information bits in a unit of m bits, the first information bits are information bits carried on the subcarrier of the first RU. and the second information bits are information bits carried on the subcarrier of the second RU.

With reference to the second aspect, in a possible implementation, there are at least two spatial data streams on the first RU and the second RU, the interleaver further includes a third interleaver, and the third interleaver is configured to connect the second interleaver and a bit parser. The third interleaver is configured to receive valid information bits output by the second interleaver by column, and perform frequency rotation on a spatial data stream other than a first spatial data stream in the at least two spatial data streams, and the first spatial data stream is one of the at least two spatial data streams. After being processed by the bit parser, valid information bits output by the third interleaver by column are sequentially output as first information bits in a unit of n bits and second information bits in a unit of m bits, the first information bits are information bits carried on the subcarrier of the first RU, and the second information bits are information bits carried on the subcarrier of the second RU.

It should be noted that the first interleaver, the second interleaver, and the third interleaver may include a hardware structure and a software module, and implement the functions in a form of the hardware structure, the software module, or a combination of the hardware structure and the software module. A function in the foregoing functions may be performed in a form of the hardware structure, the software module, or both the hardware structure and the software module.

According to a third aspect, this application provides a subcarrier mapper supporting unequal modulation. The subcarrier mapper is configured to map subcarriers of a first RU, a second RU, and a third RU, a modulation scheme of the first RU is the same as a modulation scheme of the second RU, the modulation scheme of the first RU is different from a modulation scheme of the third RU, and the subcarrier mapper includes a first unit and a second unit. The first unit is configured to map the subcarrier of the first RU and the subcarrier of the second RU based on the modulation scheme of the first RU. The second unit is configured to map the subcarrier of the third RU based on the modulation scheme of the third RU.

It should be noted that the subcarrier mapper may include a hardware structure and a software module, and implement the functions in a form of the hardware structure, the software module, or a combination of the hardware structure and the software module. A function in the foregoing functions may be performed in a form of the hardware structure, the software module, or both the hardware structure and the software module.

According to a fourth aspect, this application provides an interleaving method supporting unequal modulation. The method is applied to an interleaver, the interleaver includes a first interleaver and a second interleaver, the interleaver is configured to interleave information bits, to determine an order of information bits carried in a subcarrier of a first RU and a subcarrier of a second RU, and a modulation scheme of the first RU is different from a modulation scheme of the second RU. The method includes: The first interleaver inputs information bits by row. A quantity of columns of the first interleaver is $M_1 + M_2$, a quantity of rows of the first interleaver is a larger value in $N_1$ and $N_2$, $N_j$ is a quantity of rows determined based on a quantity of subcarriers of the first RU, $M_1$ is a quantity of columns determined based on the quantity of subcarriers of the first RU, $N_2$ is a quantity of rows determined based on a quantity of subcarriers of the second RU, $M_2$ is a quantity of columns determined based on the quantity of subcarriers of the second RU, and $N_1$, $M_1$, $N_2$, and $M_2$ are positive integers. The second interleaver receives the information bits that are output by the first interleaver by column, and performs interleaving mapping on the information bits.

With reference to the fourth aspect, in a possible implementation, that the first interleaver inputs information bits by row includes: The first interleaver inputs information bits of a first unit and information bits of a second unit by row. A quantity of columns of valid information bits of the first unit is $M_1 + M_2$, a quantity of rows of the valid information bits of the first unit is a smaller value in $N_1$ and $N_2$, and the valid information bits are bits including an information amount. A quantity of columns of valid information bits of the second unit is $M_1$ or $M_2$, and a quantity of rows of the valid information bits of the second unit is an absolute value of a difference between $N_1$ and $N_2$. A first row of the information bits of the second unit is an $(N_2 + 1)^{th}$ row of the first interleaver, and a first column of the information bits of the second unit is a first column of the interleaver; or a first row of the information bits of the second unit is an $(N_1 + 1)^{th}$ row of the first interleaver, and a first column of the information bits of the second unit is an $(M_1 + 1)^{th}$ column of the first interleaver.

With reference to the fourth aspect, in a possible implementation, that the second interleaver performs interleaving mapping on the information bits includes: The second interleaver performs interleaving mapping on information bits of a third unit and information bits of a fourth unit. That the second interleaver performs interleaving mapping on information bits of a third unit includes: The second interleaver performs interleaving mapping on valid information bits of the third unit based on a modulation order of the first RU. A quantity of columns of the valid information bits of the third unit is $M_1$, a quantity of rows of the valid information bits of the third unit is $N_1$, and the valid information bits are bits including an information amount. That the second interleaver performs interleaving mapping on information bits of a fourth unit includes: The second interleaver performs interleaving mapping on valid information bits of the fourth unit based on a modulation order of the second RU. A quantity of columns of the valid information bits of the fourth unit is $M_2$, and a quantity of rows of the valid information bits of the fourth unit is $N_2$. A first column of the information bits of the fourth unit is an $(M_1+1)^{th}$ column of the second interleaver.

With reference to the fourth aspect, in a possible implementation, there is only one spatial data stream on the first RU and the second RU, after being processed through bit parsing, valid information bits output by the second interleaver by column are carried on the subcarrier of the first RU and the subcarrier of the second RU, and the valid information bits are bits including an information amount.

With reference to the fourth aspect, in a possible implementation, there are at least two spatial data streams on the first RU and the second RU, and the interleaver further includes a third interleaver. The method further includes: The third interleaver receives valid information bits output by the second interleaver by column, and performs frequency rotation on a spatial data stream other than a first spatial data stream in the at least two spatial data streams. The first spatial data stream is one of the at least two spatial data streams, and the valid information bits are bits including an information amount. After being processed through bit parsing, valid information bits output by the third interleaver by column are carried on the subcarrier of the first RU and the subcarrier of the second RU.

According to a fifth aspect, this application provides an interleaving method supporting unequal modulation. The method is applied to an interleaver, the interleaver includes a first interleaver and a second interleaver, the interleaver is configured to interleave information bits, to determine an order of information bits carried in a subcarrier of a first RU and a subcarrier of a second RU, and a modulation scheme of the first RU is different from a modulation scheme of the second RU. The method includes: The first interleaver inputs information bits by row. A quantity of rows of the first interleaver is $i \times (n + m)$, a quantity of columns of the first interleaver is $j/i$, $i$ is a positive integer, $n$ is a modulation order of the first RU, $m$ is a modulation order of the second RU, and $j$ is a larger value in a quantity of subcarriers of the first RU and a quantity of subcarriers of the second RU. The second interleaver receives the information bits that are output by the first interleaver by column, and performs interleaving mapping on the information bits.

With reference to the fifth aspect, in a possible implementation, that the first interleaver inputs information bits by row includes: The first interleaver inputs information bits of $i$ first units and information bits of $i$ second units by row. A quantity of columns of valid information bits of the first unit is less than or equal to the quantity of columns of the first interleaver, a total quantity of rows of valid information bits of the $i$ first units is $n \times i$, and the valid information bits are bits including an information amount. A quantity of columns of valid information bits of the second unit is less than or equal to the quantity of columns of the first interleaver, and a total quantity of rows of valid information bits of the $i$ second units is $m \times i$. A quantity of rows of the first interleaver corresponding to a first row of information bits of an $a^{th}$ first unit is $(a - 1) \times n + (a - 1) \times m + 1$, and $a$ is a positive integer less than or equal to $i$. A quantity of rows of the first interleaver corresponding to a first row of information bits of a $b^{th}$ second unit is $b \times n + (b - 1) \times m + 1$, and $b$ is a positive integer less than or equal to $i$.

With reference to the fifth aspect, in a possible implementation, that the second interleaver performs interleaving mapping on the information bits includes: The second interleaver performs interleaving mapping on information bits of $i$ third units and information bits of $i$ fourth units. That the second interleaver performs interleaving mapping on information bits of $i$ third units includes: The second interleaver performs interleaving mapping on valid information bits of the third unit based on the modulation order of the first RU, a quantity of columns of the valid information bits of the third unit is less than or equal to the quantity of columns of the first interleaver, a total quantity of rows of valid information bits of the $i$ third units is $n \times i$, and the valid information bits are bits including an information amount. That the second interleaver performs interleaving mapping on information bits of $i$ fourth units includes: The second interleaver performs interleaving mapping on valid information bits of the fourth unit based on the modulation order of the second RU, a quantity of columns of the valid information bits of the fourth unit is less than or equal to the quantity of columns of the first interleaver, and a total quantity of rows of valid information bits of the $i$ fourth units is $m \times i$. A quantity of rows of the second interleaver corresponding to a first row of information bits of a $c^{th}$ third unit is $(c - 1) \times n + (c - 1) \times m + 1$. and $c$ is a positive integer less than or equal to $i$. A quantity of rows of the second interleaver corresponding to a first row of information bits of a $d^{th}$ fourth unit is $d \times n + (d - 1) \times m + 1$, and $d$ is a positive integer less than or equal to $i$.

With reference to the fifth aspect, in a possible implementation, there is only one spatial data stream on the first RU and the second RU. After being processed through bit parsing, valid information bits output by the second interleaver by column are sequentially output as first information bits in a unit of $n$ bits and second information bits in a unit of $m$ bits, the first information bits are information bits carried on the subcarrier of the first RU, and the second information bits are information bits carried on the subcarrier of the second RU.

With reference to the fifth aspect, in a possible implementation, there are at least two spatial data streams on the first RU and the second RU. The method further includes: A third interleaver receives valid information bits output by the second interleaver by column, and performs frequency rotation on a spatial data stream other than a first spatial data stream in the at least two spatial data streams. The first spatial data stream is one of the at least two spatial data streams. After being processed through bit parsing, valid information bits output by the third interleaver by column are sequentially output as first information bits in a unit of n bits and second information bits in a unit of m bits, the first information bits are information bits carried on the subcarrier of the first RU, and the second information bits are information bits carried on the subcarrier of the second RU.

According to a sixth aspect, this application provides a subcarrier mapping method supporting unequal modulation. The method is applied to a subcarrier mapper, and the subcarrier mapper includes a first unit and a second unit. The subcarrier mapper is configured to map subcarriers of the first RU, the second RU, and a third RU, a modulation scheme of the first RU is the same as a modulation scheme of the second RU, the modulation scheme of the first RU is different from a modulation scheme of the third RU, and the subcarrier mapper includes a first unit and a second unit. The method includes: The first unit maps the subcarrier of the first RU and the subcarrier of the second RU based on the modulation scheme of the first RU. The second unit maps the subcarrier of the third RU based on the modulation scheme of the third RU.

According to a seventh aspect, this application provides a computer-readable storage medium. The computer-readable storage medium is configured to store instructions, and when the instructions are executed, the method in any one of the fourth aspect or the possible implementations of the fourth aspect is implemented, the method in any one of the fifth aspect or the possible implementations of the fifth aspect is implemented, or the method in any one of the sixth aspect or the possible implementations of the sixth aspect is implemented.

According to an eighth aspect, this application provides another computer-readable storage medium. The computer-readable storage medium is configured to store instructions, and when the instructions are executed, the method in any one of the fourth aspect or the possible implementations of the fourth aspect is implemented, the method in any one of the fifth aspect or the possible implementations of the fifth aspect is implemented, or the method in any one of the sixth aspect or the possible implementations of the sixth aspect is implemented.

According to a ninth aspect, this application provides a chip system. The chip system includes at least one processor and an interface, and is configured to support an interleaver in implementing functions, for example, receiving or processing at least one of data and information related to the method, in the fifth aspect or the sixth aspect. In a possible design, the chip system further includes a memory. The memory is configured to store necessary program instructions and data of the interleaver. The chip system may include a chip, or may include a chip and another discrete component.

According to a tenth aspect, this application provides another chip system. The chip system includes at least one processor and an interface, and is configured to support a subcarrier mapper in implementing functions, for example, receiving or processing at least one of data and information related to the method, in the seventh aspect. In a possible design, the chip system further includes a memory. The memory is configured to store necessary program instructions and data of the subcarrier mapper. The chip system may include a chip, or may include a chip and another discrete component.

In embodiments of this application, a unified interleaver can interleave information bits of a plurality of RUs using different modulation and coding schemes, or a unified subcarrier mapper can map subcarriers of a plurality of RUs using different modulation and coding schemes. This can simplify a hardware structure of a communication device, and reduce hardware costs.


**DESCRIPTION OF DRAWINGS**

To describe technical solutions in embodiments of this application or in the conventional technology more clearly, the following briefly describes the accompanying drawings required for describing the embodiments or the conventional technology.

FIG. 1 is a schematic diagram of an architecture of a data communication system according to an embodiment of this application;
FIG. 2A is a schematic diagram of a tone plan and RU distribution according to an embodiment of this application;
FIG. 2B is a schematic diagram of another tone plan and RU distribution according to an embodiment of this application;
FIG. 2C is a schematic diagram of another tone plan and RU distribution according to an embodiment of this application;
FIG. 3 is a schematic diagram of a system implementing BICM according to an embodiment of this application;
FIG. 4 is a schematic diagram of an interleaver according to an embodiment of this application;
FIG. 5 is a schematic diagram of another interleaver according to an embodiment of this application;

FIG. 6 is a schematic diagram of an interleaving system according to an embodiment of this application;

FIG. 7 is a schematic diagram of another system implementing BICM according to an embodiment of this application;

FIG. 8 is a schematic diagram of a first interleaver according to an embodiment of this application;

FIG. 9 is a schematic diagram of another first interleaver according to an embodiment of this application;

FIG. 10 is a schematic diagram of a second interleaver according to an embodiment of this application;

FIG. 11 is a schematic diagram of another second interleaver according to an embodiment of this application;

FIG. 12 is a schematic diagram of another first interleaver according to an embodiment of this application;

FIG. 13 is a schematic diagram of another first interleaver according to an embodiment of this application;

FIG. 14 is a schematic diagram of another second interleaver according to an embodiment of this application;

FIG. 15 is a schematic diagram of another second interleaver according to an embodiment of this application;

FIG. 16 is a schematic diagram of another system implementing BICM according to an embodiment of this application;

FIG. 17 is a schematic diagram of a processing system according to an embodiment of this application;

FIG. 18 is a schematic diagram of another system implementing BICM according to an embodiment of this application;

FIG. 19 is a schematic diagram of an LDPC tone mapper according to an embodiment of this application;

FIG. 20 is a schematic diagram of another LDPC tone mapper according to an embodiment of this application;

FIG. 21 is a schematic flowchart of an interleaving method supporting unequal modulation according to an embodiment of this application; and

FIG. 22 is a schematic flowchart of a subcarrier mapping method supporting unequal modulation according to an embodiment of this application not encompassed by the wording of the claims.

## DESCRIPTION OF EMBODIMENTS

The following describes in detail technical solutions in embodiments of this application.

The technical solutions in this application may be applied to a wireless local area network (Wireless Local Area Network, WLAN), an Internet of things (Internet of Things, IOT) network, a vehicle-to-X (Vehicle-to-X, V2X) network, another network, or the like. This is not specifically limited in this application. For example, an application scenario of this application may be a WLAN according to the Institute of Electrical and Electronics Engineers (Institute of Electrical and Electronics Engineers, IEEE) 802.11be standard, an IoT network according to the IEEE 802.11be standard, a vehicle-to-X network according to the IEEE 802.11be standard, another network according to the IEEE 802.11be standard, a next generation WLAN according to the IEEE 802.11be standard, an IoT network according to a next generation standard of the IEEE 802.11be standard, a vehicle-to-X network according to a next generation standard of the IEEE 802.11be standard, another network according to a next generation standard of the IEEE 802.11be standard, or another WLAN according to a future standard protocol.

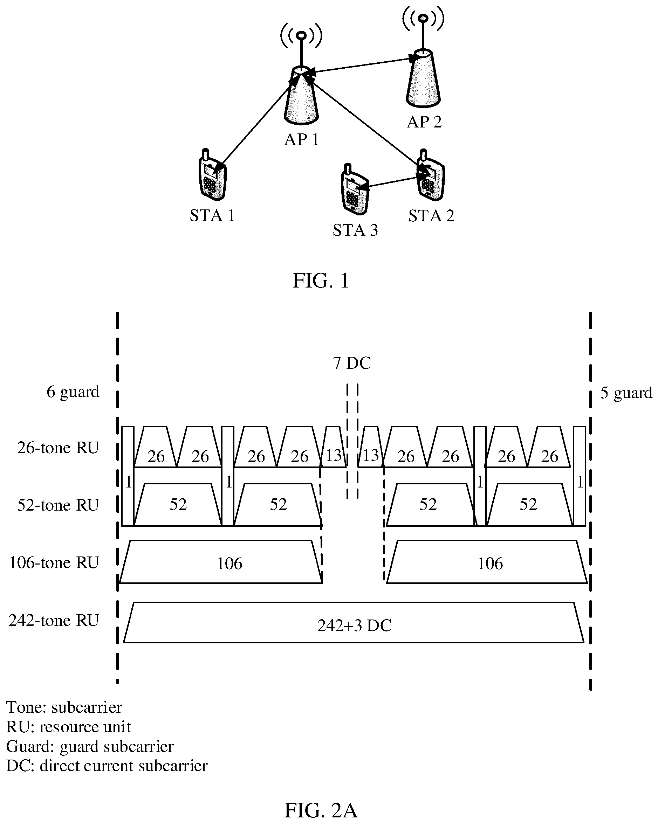

A data communication system provided in an embodiment of this application includes one or more access points (access point, AP) and one or more stations (station, STA). For example, FIG. 1 is a schematic diagram of an architecture of a data communication system according to an embodiment of this application. The data communication system includes two APs and three STAs. The two APs are a first AP (AP 1) and a second AP (AP 2), and the three STAs are a first STA (STA 1), a second STA (STA 2), and a third STA (STA 3). It should be noted that the data communication system includes at least two devices, and may include more or fewer devices than those in FIG. 1. This is not limited herein, and FIG. 1 is merely used as an example.

The following further describes the two types of devices.

The STA in embodiments of this application is an apparatus having a wireless communication function, and may be user equipment, an access terminal, a subscriber unit, a subscriber station, a mobile station, a mobile console, a remote station, a remote terminal, a mobile device, a user terminal, a terminal, a wireless communication device, a user agent, or a user apparatus. The station may alternatively be a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, a vehicle-mounted device, a wearable device, a terminal device in a future 5G network, a terminal device in a future evolved public land mobile network (public land mobile network, PLMN), or the like. This is not limited in embodiments of this application.

The AP in embodiments of this application may be an access point for a terminal device (such as a mobile phone) to access a wired (or wireless) network, and is mainly deployed in a home, a building, and a park. A typical coverage radius is tens of meters to hundreds of meters. It is clear that the AP may alternatively be deployed outdoors. The access point is equivalent to a bridge that connects the wired network and the wireless network. A main function of the access point is to connect various wireless network clients together and then connect the wireless network to the Ethernet. Specifically, the access point may be a terminal device (for example, a mobile phone) or a network device (for example, a router) with a wireless fidelity (wireless fidelity, Wi-Fi) chip. The access point may be a device that supports the 802.11be standard. Alternatively, the access point may be a device that supports a plurality of wireless local area network (wireless local area network, WLAN) standards of the 802.11 family such as the 802.11be standard, the 802.11ax standard, the 802.11ac standard, the 802.11n standard, the 802.11g standard, the 802.11b standard, and the 802.11a standard. The access point in this application may be a high-efficiency (high-efficiency, HE) AP, an extremely high throughput (extremely high throughput, EHT) AP, or an access point applicable to a future generation Wi-Fi standard.

A resource unit (resource unit, RU) in embodiments of this application is a basic frequency resource unit for dividing frequency resources of a wireless network. Types of RU include a 26-tone RU, a 52-tone RU, a 106-tone RU, a 242-tone RU, a 484-tone RU, a 996-tone RU, a 2*996-tone RU, and the like. Herein, tone indicates a subcarrier. As a basic frequency resource unit, RUs can be allocated to different users for uplink and downlink data transmission. RUs of different sizes have different bandwidths, and can also carry services of different rates. Subcarriers of an RU include a valid (or referred to as data) subcarrier and a pilot subcarrier. The data subcarrier is used to carry an information bit required for communication, and the pilot subcarrier is used to carry data known by both communication parties, to perform channel estimation. For example, the 26-tone RU includes 24 data subcarriers and two pilot subcarriers, and the 52-tone RU includes 48 data subcarriers and four pilot subcarriers.

The following describes tone plans (Tone Plan) in different data packet bandwidths. FIG. 2A is a schematic diagram of a tone plan and RU distribution according to an embodiment of this application. When a bandwidth is 20 MHz, the entire bandwidth may include an entire 242-tone RU or any combination of a 26-tone RU, a 52-tone RU, and a 106-tone RU. In addition to the RU used for data transmission, the bandwidth further includes some guard (Guard) subcarriers, null subcarriers (parts indicated by a 1 tone in FIG. 2A), or direct current (Direct Current, DC) subcarriers.

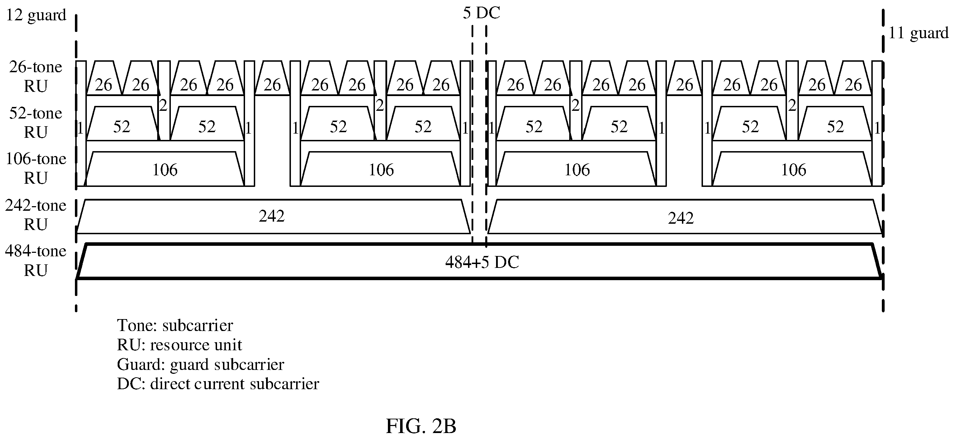

FIG. 2B is a schematic diagram of another tone plan and RU distribution according to an embodiment of this application. When a bandwidth is 40 MHz, the entire bandwidth is approximately equivalent to replication of two tone plans of 20 MHz, and may include an entire 484-tone RU or any combination of a 26-tone RU, a 52-tone RU, a 106-tone RU, and a 242-tone RU. The null subcarriers include parts indicated by a 1 tone and 2 tones in the example in FIG. 2B.

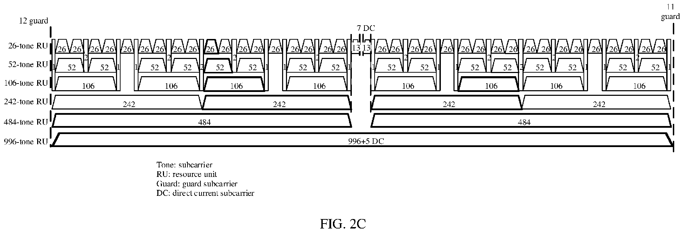

FIG. 2C is a schematic diagram of another tone plan and RU distribution according to an embodiment of this application. When a bandwidth is 80 MHz, the entire bandwidth includes four 242-tone resource units. Particularly, in the middle of the entire bandwidth, there is an intermediate 26-tone RU including two 13-tone subunits. The entire bandwidth may include an entire 996-tone RU or any combination of a 26-tone RU, a 52-tone RU, a 106-tone RU, a 242-tone RU, and a 484-tone RU. The null subcarriers include parts indicated by a 1 tone and 2 tones in the example in FIG. 2C.

The rest can be deduced by analogy. When a bandwidth is 160 MHz or 80+80 MHz, the entire bandwidth may be considered as replication of two tone plans of 80 MHz, and may include an entire 2*996-tone RU or any combination of a 26-tone RU, a 52-tone RU, a 106-tone RU, a 242-tone RU, 484-tone RU, and a 996-tone RU. A difference between 160 MHz and 80+80 MHz lies in that the 160 MHz bandwidth is a continuous frequency band, and the 80+80 MHz bandwidth may be separated as two 80 MHz frequency bands.

Currently, to improve spectrum usage and transmission reliability of a wireless communication system, an orthogonal frequency division multiplexing (Orthogonal Frequency Division Multiplexing, OFDM) technology is widely used in the WLAN standard (for example, 802.11a/n/ac). As a multi-carrier technology, the OFDM technology divides a channel into several orthogonal sub-channels, converts a high-speed data signal into parallel low-speed substreams, and modulates the data streams to transmit on the sub-channels. OFDM carriers are orthogonal to each other. Each carrier has an integer quantity of subcarrier periods in a symbol time, and a spectrum zero point of each carrier overlaps a zero point of an adjacent carrier, to reduce interference between carriers. Because carriers partially overlap with each other, compared with the conventional frequency division multiplexing (FDM) technology, the OFDM technology improves frequency band usage, and provides better anti-frequency selective fading performance than that of a conventional single-carrier system.

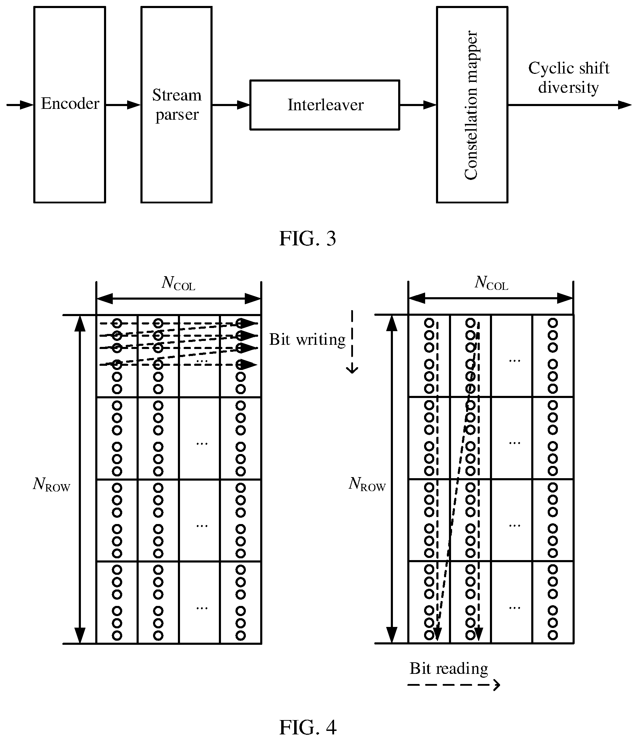

In addition, to further improve transmission reliability of the system, a plurality of wireless communication standards (for example, high speed packet access (high speed packet access, HSPA), long term evolution (long term evolution, LTE), and the IEEE 802.11a/g/n/ac standard) combine the OFDM technology and a bit-interleaved coded modulation (bit-interleaved coded modulation, BICM) technology. By using the BICM technology, an information bit sequence may be interleaved before OFDM modulation, to obtain a frequency domain coding diversity gain in a wireless fading channel. FIG. 3 is a schematic diagram of a system implementing BICM according to an embodiment of this application. The system includes an encoder, a stream parser, an interleaver, and a constellation mapper. The encoder is configured to encode a bit stream or data, and convert the bit stream or the data into a signal form (for example, a data stream) that can be used for communication, transmission, and storage. For example, the encoder may be a binary convolutional code (Binary Convolutional Code, BCC) encoder. The stream parser is configured to allocate encoded information bits to different data streams. For a data stream, the stream parser may intercept information bits based on a quantity of subcarriers and a modulation order that correspond to an allocated RU, and then input the information bits to the interleaver. The interleaver is configured to interleave the information bits in the data stream, to determine an order of the information bits carried on subcarriers of the RU. The constellation mapper is configured to map, based on the modulation order of the RU, the information bits output by the interleaver to the subcarrier. For example, if the modulation order of the RU is 6, the constellation mapper maps six information bits to one point of the subcarrier. Then, cyclic shift diversity processing is performed on the subcarriers. In the BICM system, a channel coding gain may be increased by using a cascaded interleaver, to effectively improve system transmission reliability. It should be noted that FIG. 3 is a diagram of a framework of the system. During actual application, there may be one or more components shown in the figure. The constellation mapper is used as an example. FIG. 3 shows an example of one constellation mapper. However, during actual application, the system may include a plurality of constellation mappers, to implement functions implemented by the constellation mapper.

The following further describes an interleaver (which may be understood as a conventional interleaver). As shown in FIG. 3, an interleaver is serially cascaded between a BCC encoder and a constellation mapper, and the interleaver is configured to interleave information bits of an OFDM symbol, to obtain frequency domain coding diversity. In other words, the interleaver may distribute the bits of the OFDM symbol, to avoid strings of bit errors. This can improve information transmission reliability.

The information bits processed by the interleaver are carried on subcarriers of one RU. In other words, there is a correspondence between the interleaver and the one RU. A quantity of rows and a quantity of columns of the interleaver may be determined based on a quantity of subcarriers of an RU corresponding to the interleaver. For example, $N_{COL}$ is the quantity of columns of the interleaver, and $N_{ROW}$ is the quantity of rows of the interleaver. Specifically, $N_{ROW} = x \cdot N_{BPSCS}$, and $x \cdot N_{COL} = N_{SD}$. x is a positive integer, $N_{BPSCS}$ is a modulation order of the RU corresponding to the interleaver, and $N_{SD}$ (Number of data subcarriers) is a quantity of valid (or referred to as data) subcarriers of the RU corresponding to the interleaver. In a possible implementation, a quantity of rows and a quantity of columns of an interleaver corresponding to each of RUs with different quantities of subcarriers may be specified in a protocol. Refer to Table 1. Table 1 shows BCC interleaver parameters (BCC interleaver parameters) specified in the IEEE 802.11ax standard.

**Table 1**

| Dual carrier modulation (dual carrier modulation, DCM) | Parameter (parameter) | Resource unit size (tone) RU size (tones) | | | | High efficient signal field A/High efficient signal field B (tone) HE-SIG-A/HE-SIG-B (tones) |
|---|---|---|---|---|---|---|
| | | 26 | 52 | 106 | 242 | 56 |
| Not used (Not used) | $N_{COL}$ | 8 | 16 | 17 | 26 | 13 |
| | $N_{ROW}$ | $3 \cdot N_{BPSCS}$ | $3 \cdot N_{BPSCS}$ | $6 \cdot N_{BPSCS}$ | $9 \cdot N_{BPSCS}$ | $4 \cdot N_{BPSCS}$ |
| | $N_{ROT}$ | 2 | 11 | 29 | 58 | - |
| Used (Used) | $N_{COL}$ | 4 | 8 | 17 | 13 | 13 |
| | $N_{ROW}$ | $3 \cdot N_{BPSCS}$ | $3 \cdot N_{BPSCS}$ | $3 \cdot N_{BPSCS}$ | $9 \cdot N_{BPSCS}$ | $2 \cdot N_{BPSCS}$ |
| | $N_{ROT}$ | 2 | 2 | 11 | 29 | - |

$N_{ROT}$ is a parameter for frequency rotation (parameter for the frequency rotation). For example, a quantity of rows and a quantity of columns of the interleaver corresponding to the 26-tone RU may be $3 \times N_{BPSCS}$ and 8, $x \cdot N_{COL} = 3 \times 8 = 24$, and a quantity of valid subcarriers of the 26-tone RU is 24. A quantity of rows and a quantity of columns of the interleaver corresponding to the 52-tone RU may be $3 \times N_{BPSCS}$ and 16, $x \cdot N_{COL} = 3 \times 16 = 48$, and a quantity of valid subcarriers of the 52-tone RU is 48.

For example, the interleaver may include three interleavers (for example, an interleaver 1, an interleaver 2, and an interleaver 3) that are serially cascaded. The following further describes the three interleavers. It should be noted that quantities of rows and quantities of columns of the three interleavers are the same, and are determined based on a quantity of subcarriers of an RU corresponding to the interleaver.

FIG. 4 is a schematic diagram of an interleaver according to an embodiment of this application. Specifically, the left part of FIG. 4 shows that the interleaver 1 inputs information bits by row, and the right part of FIG. 4 shows that the interleaver 1 outputs the information bits by column. The interleaver 1 is configured to reorder an order of adjacent information bits in a row-in and column-out manner. In FIG. 4, one circle indicates one information bit. Specifically, the interleaver 1 is configured to sequentially input the information bits by row, that is, fill the information bits into rows in a sequence of a first row, a second row, ..., and an $N_{ROW}$th row. After information bits are filled into one row, information bits are filled into a next row. Then, the information bits are sequentially output by column, that is, the information bits are read in a sequence of a first column, a second column, ..., and an $N_{COL}$th column. After information bits in one column are read, information bits in a next column are read. In this manner, adjacent information bits may be mapped to non-adjacent OFDM subcarriers.

For example, a parameter of the interleaver 1 is ($N_{ROW}$, $N_{COL}$). It is assumed that a sequence before interleaving is X ($X_0$, $X_1$..., $X_k$, ...), a sequence after interleaving is W ($W_0$, $W_1$..., $W_i$,...), and bits before and after interleaving are respectively $X_k$ (namely, a (k+1)th information bit in the sequence X before interleaving) and $W_i$ (namely, an (i+1)th information bit in the sequence W after interleaving). An interleaving formula of the interleaver 1 is shown in Formula 1-1. It may be understood that the interleaving formula may indicate a location relationship of a same information bit in the sequence before interleaving and the sequence after interleaving.

$$i = N_{ROW} \cdot (k \bmod N_{COL}) + \left\lfloor \frac{k}{N_{COL}} \right\rfloor \quad \text{Formula 1-1}$$

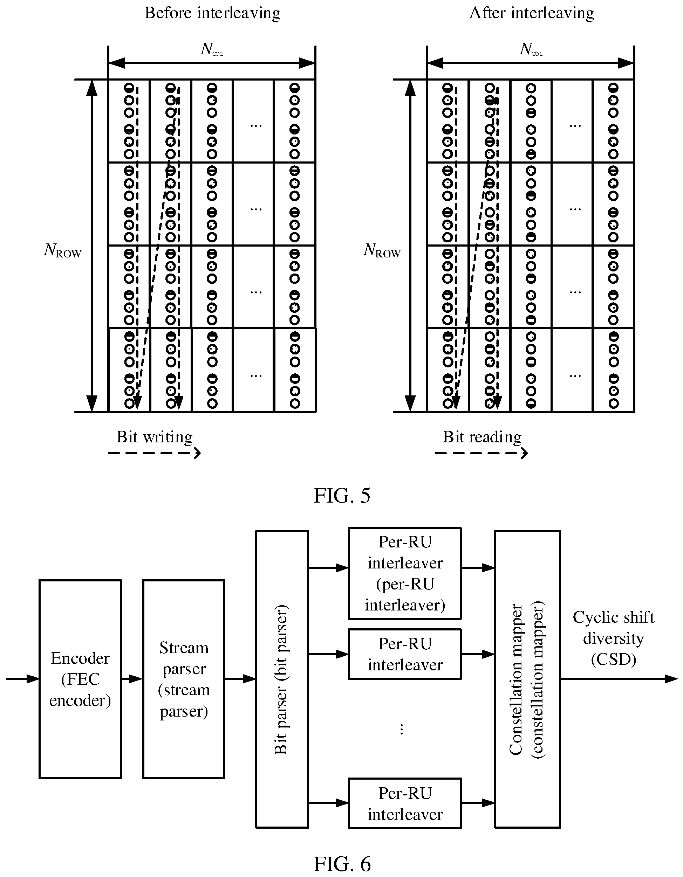

FIG. 5 is a schematic diagram of another interleaver according to an embodiment of this application. The left part of FIG. 5 shows that a sequence of information bits before the interleaver 2 processes the information bits, and the right part of FIG. 5 shows that a sequence of information bits after the interleaver 2 processes the information bits. The interleaver 2 is configured to receive the information bits output by the interleaver 1 by column, and perform interleaving mapping on the information bits. Then, if the interleaver 3 exists, the interleaver 2 inputs the processed information bits to the interleaver 3. If the interleaver 3 does not exist, the interleaver 2 inputs the processed information bits to a constellation mapper. Interleaving mapping means reordering a sequence of information bits in every s adjacent information bits. A specific manner may be performing downward cyclic shift on a latter column of two adjacent columns of information bits. $s$ = max {1, $m/2$}, $m$=$\log_2 M$, and $M$ is a constellation point modulation order. In this manner, adjacent information bits may be mapped to a least significant bit (LSB) and a most significant bit (MSB) in a constellation diagram in an interleaving manner, to prevent the information bits from being continuously mapped to the least significant bit.

In the example shown in FIG. 5, $m$=$\log_2 M$=$\log_2 64$=6, and $s$ = max{1, $m/2$}=3. The interleaver 2 is configured to reorder an order of information bits in every three adjacent information bits. In FIG. 5, one circle indicates one information bit. It should be noted that circles in different forms are only used to distinguish between different information bits in every three adjacent information bits, and circles in a same form do not indicate that information bits are the same. For example, in an interleaving process, three adjacent information bits may be considered as a group. In comparison with the first three information bits in the second row, in the first three information bits in the first row, the first information bit is moved downwards by one bit and becomes the second information bit, the second information bit is moved downwards by one bit and becomes the third information bit, and the third information bit is moved downwards by one bit. Because the fourth bit does not exist, the third information bit becomes the first information bit. Similarly, the same processing is also performed on other information bits in the first row. In addition, in comparison with information bits in the second row, similar downward cyclic shift is performed on information bits in the third row.

For example, it is assumed that a sequence before interleaving is H ($H_0$, $H_1$..., $H_k$, ...), a sequence after interleaving is Y ($Y_0$, $Y_1$..., $Y_j$, ...), and bits before and after interleaving are respectively $H_k$ (namely, a (k+1)th information bit in the sequence H before interleaving) and $Y_j$ (namely, a (j+1)th information bit in the sequence Y after interleaving). An interleaving formula of the interleaver 2 is shown in Formula 1-2.

$$j = s \cdot \left\lfloor \frac{k}{s} \right\rfloor + \left( k + N_{CBPSS} - \left\lfloor \frac{N_{COL} \cdot k}{N_{CBPSS}} \right\rfloor \right) \bmod s \quad \text{1-2}$$

$N_{CBPSS}$ is a quantity of coded bits in each spatial data stream.

The following describes the interleaver 3. Specifically, if there are at least two spatial data streams on the RU corresponding to the interleaver, the interleaver 3 exists, and is connected to the constellation mapper. If there is only one spatial data stream on the RU corresponding to the interleaver, the interleaver includes only the interleaver 1 and the interleaver 2, and the interleaver 2 is connected to the constellation mapper. The spatial data streams are different data streams generated after the stream parser divides information bits into a plurality of parallel information bits.

The interleaver 3 is configured to perform frequency rotation on a spatial data stream other than a first spatial data stream in the at least two spatial data streams, where the first spatial data stream is one of the at least two spatial data streams. For example, there are a spatial data stream A and a spatial data stream B on the RU, a first spatial data stream may be the spatial data stream A, and the interleaver 3 performs frequency rotation on the spatial data stream B.

For example, it is assumed that a sequence before interleaving is Q ($Q_0$, $Q_1$..., $Q_k$, ...), a sequence after interleaving is Z ($Z_0$, $Z_1$..., $Z_r$, ...), and bits before and after interleaving are respectively $Q_k$ (namely, a (k+1)th information bit in the sequence Q before interleaving) and $Z_r$ (namely, an (r+1)th information bit in the sequence Z after interleaving). An interleaving formula of the interleaver 3 may be shown in Formula 1-3.

$$r = \left( k - \left( \left( (i_{SS} - 1) \cdot 2 \right) \mod 3 + 3 \cdot \left\lfloor \frac{i_{SS} - 1}{3} \right\rfloor \right) \cdot N_{ROT} \cdot m \right) \mod N_{CBPSS} \quad 1\text{-}3$$

$i_{SS}$ indicates a sequence number of a current spatial data stream, $N_{CBPSS}$ is a quantity of coded bits in each spatial data stream, $N_{ROT}$ is a frequency rotation parameter, $m = \log_2 M$, and $M$ is a constellation point modulation order.

To further improve allocation flexibility and spectrum usage of the wireless communication system, when a plurality of RUs may be allocated to one user, different modulation and coding schemes (Modulation and Coding Scheme, MCS) may be configured for the plurality of RUs of the same user. In other words, the plurality of RUs support unequal modulation (Unequal Modulation, UEQM). Currently, one interleaver only processes an RU using only one modulation scheme. Information bits of each of the plurality of RUs are interleaved by using a single interleaver, to process information bits of the plurality of RUs using different MCSs.

FIG. 6 is a schematic diagram of an interleaving system according to an embodiment of this application. FIG. 6 includes two levels of processing units. A first-level processing unit allocates information bits in an interleaving manner based on different RUs of a user by using a bit parser, and a second-level processing unit interleaves the information bits of the RUs by using a plurality of per-RU interleavers. For one per-RU interleaver, refer to the foregoing descriptions. The per-RU interleaver may include an interleaver 1 and an interleaver 2, or may include an interleaver 1, an interleaver 2, and an interleaver 3. In this manner, a plurality of per-RU interleavers (per-RU interleaver) need to be designed for different RUs allocated to a single user. One per-RU interleaver corresponds to one RU, and one per-RU interleaver supports an MCS of a corresponding RU. In other words, UEQM with a plurality of RUs can be implemented. For a user, in this manner, user equipment needs to support a plurality of RU interleavers in parallel, and hardware costs are high.

With reference to the data communication system, the STA, and the AP described in the foregoing content, the following describes an interleaver supporting unequal modulation provided in embodiments of this application. The interleaver method may be implemented based on the data communication system shown in FIG. 1. A communication device using the interleaver may be the STA or the AP in the data communication system shown in FIG. 1. Information processed by the interleaver may be transmitted between STAs, between APs, and between the STA and the AP. It should be noted that an information transmitter may process information bits by using the interleaver described in embodiments of this application. Correspondingly, an information receiver may parse the information bits by using a de-interleaver corresponding to the interleaver. A de-interleaving process is an inverse operation of an interleaving operation. In another possible implementation, a communication device using the interleaver may alternatively be a multi-link device (multi-link device, MLD).

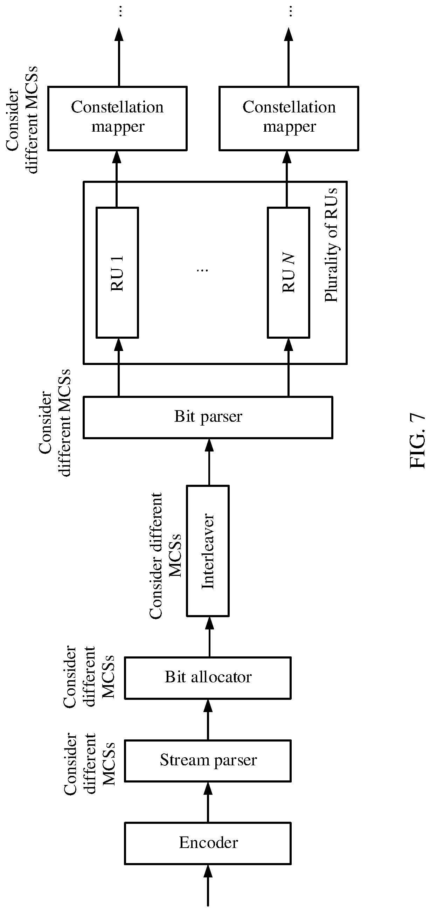

First, the following describes a system that implements BICM and to which the interleaver in embodiments of this application is applied. FIG. 7 is a schematic diagram of another system implementing BICM according to an embodiment of this application. The system includes apparatuses such as an encoder, a stream parser, a bit allocator, an interleaver, a bit parser, and a constellation mapper. The stream parser is configured to divide a data stream. The bit allocator is configured to select a specific quantity of information bits and input the information bits to the interleaver. The bit parser is configured to distribute a stream of information bits on a plurality of RUs and input the stream of information bits to the constellation mapper. When the interleaver supports UEQM, the modules need to consider different modulation schemes of the RUs. For example, for the constellation mapper, when a modulation order is 4, every four bits are mapped to one constellation point. When the modulation order is 6, every six bits are mapped to one constellation point. For another example, the stream parser may intercept information bits based on quantities of subcarriers and modulation orders that correspond to a plurality of allocated RU. In addition, in the schematic diagram, there may also be a single constellation mapper, that is, parallel mapping in FIG. 7 becomes serial mapping.

The following further describes the interleaver in embodiments of this application. Specifically, an example in which a first RU and a second RU are allocated to user equipment in which the interleaver is located is used for description. A modulation scheme of the first RU is different from a modulation scheme of the second RU. The interleaver is configured to interleave information bits, to determine an order of information bits carried in a subcarrier of the first RU and a subcarrier of the second RU.

The interleaver provided in embodiments of this application may include a first interleaver and a second interleaver. For a function of the first interleaver, refer to the descriptions of the interleaver 1 in the conventional interleaver in the foregoing content. The first interleaver is configured to reorder an order of adjacent information bits in a row-in and column-out manner. In some embodiments, a quantity of columns of the first interleaver is $M_1 + M_2$, and a quantity of rows of the first interleaver is a larger value in $N_1$ and $N_2$. $N_1$ is a quantity of rows determined based on a quantity of subcarriers of the first RU, $M_1$ is a quantity of columns determined based on the quantity of subcarriers of the first RU, $N_2$ is a quantity of rows determined based on a quantity of subcarriers of the second RU, $M_2$ is a quantity of columns determined based on the quantity of subcarriers of the second RU, and $N_1$, $M_1$, $N_2$, and $M_2$ are positive integers. It may be understood that $M_1$ is a quantity of columns of the conventional interleaver corresponding to the first RU described in the foregoing content, and $N_1$

is a quantity of rows of the conventional interleaver corresponding to the first RU described in the foregoing content. $M_2$ is a quantity of columns of the conventional interleaver corresponding to the second RU described in the foregoing content, and $N_2$ is a quantity of rows of the conventional interleaver corresponding to the second RU described in the foregoing content. In a possible implementation, a quantity of rows and a quantity of columns of an interleaver corresponding to each of RUs with different quantities of subcarriers may be specified in a protocol.

Specifically, the first interleaver is configured to input information bits of a first unit and information bits of a second unit by row. A quantity of columns of valid information bits of the first unit is $M_1+M_2$, and a quantity of rows of the valid information bits of the first unit is a smaller value in $N_1$ and $N_2$. A quantity of columns of valid information bits of the second unit is $M_1$ or $M_2$, and a quantity of rows of the valid information bits of the second unit is an absolute value of a difference between $N_1$ and $N_2$. A first row of the information bits of the second unit is an $(N_2+1)^{th}$ row of the first interleaver, and a first column of the information bits of the second unit is a first column of the interleaver; or a first row of the information bits of the second unit is an $(N_1+1)^{th}$ row of the first interleaver, and a first column of the information bits of the second unit is an $(M_1+1)^{th}$ column of the first interleaver. The valid information bits are bits including an information amount. The valid information bits are information bits that are encoded by an encoder and actually input to the interleaver, and then are carried on subcarriers.

It should be noted that, during actual application, the first interleaver may input and output the information bits of the first unit and the information bits of the second unit by using hardware, software, or a combination of software and hardware. In a possible implementation, the first interleaver is implemented by using hardware. The first interleaver may be divided into a first part and a second part. The first part is used to input the information bits of the first unit, and the second part is used to input the information bits of the second unit. In another possible implementation, the first interleaver is implemented by using software. The first interleaver determines, in a matrix manner, coordinates of each information bit that can be input by the first interleaver. The first interleaver may determine coordinates of the information bits of the first unit based on a quantity of rows and a quantity of columns of the information bits of the first unit, and determine coordinates of the information bits of the second unit based on a quantity of rows and a quantity of columns of the information bits of the second unit.

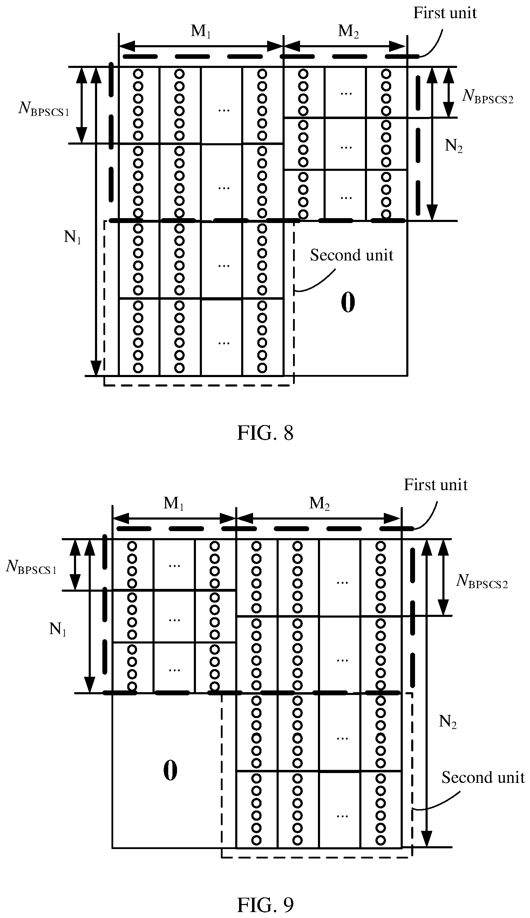

FIG. 8 is a schematic diagram of the first interleaver according to an embodiment of this application. In the example in FIG. 8, a quantity of subcarriers of the first RU is greater than a quantity of subcarriers of the second RU, and $N_1$ is greater than $N_2$. $N_{PBSCS1}$ is a modulation order of the first RU, and $N_{PBSCS2}$ is a modulation order of the second RU. A circle in FIG. 8 may indicate a valid information bit. A part marked as 0 is invalid information bits, and the bits may be 0; or may be null, and does not include any information bit. For similar symbols in subsequent content, refer to meanings herein. Details are not described again. For the first unit and the second unit, refer to dashed-line boxes in FIG. 8. The first unit indicates a part occupied by the information bits of the first unit, and the second unit indicates a part occupied by the information bits of the second unit. A quantity of columns of valid information bits of the first unit is $M_1+M_2$, and a quantity of rows of the valid information bits of the first unit is $N_2$. A quantity of columns of valid information bits of the second unit is $M_1$, and a quantity of rows of the valid information bits of the second unit is $N_1-N_2$. A first row of the information bits of the second unit is an $(N_2+1)^{th}$ row of the first interleaver, and a first column of the information bits of the second unit is a first column of the interleaver. In a possible implementation, there may be an invalid information bit in the information bits of the second unit. In this case, the second unit may include the part in the dashed-line box representing the second unit and the part marked as 0 shown in FIG. 8.

FIG. 9 is a schematic diagram of another first interleaver according to an embodiment of this application. In the example in FIG. 9, a quantity of subcarriers of a first RU is less than a quantity of subcarriers of a second RU, and $N_1$ is less than $N_2$. $N_{PBSCS1}$ is a modulation order of the first RU, and $N_{PBSCS2}$ is a modulation order of the second RU. A quantity of columns of valid information bits of a first unit is $M_1+M_2$, and a quantity of rows of the valid information bits of the first unit is a $N_1$. A quantity of columns of valid information bits of the second unit is $M_2$, and a quantity of rows of the valid information bits of the second unit is $N_2-N_1$. A first row of the information bits of the second unit is an $(N_1+1)^{th}$ row of the first interleaver, and a first column of the information bits of the second unit is an $(M_1+1)^{th}$ column of the first interleaver. Similarly, there may be an invalid information bit in the information bits of the second unit. In this case, the second unit may include the part in the dashed-line box representing the second unit and the part marked as 0 shown in FIG. 9.

In the foregoing example, an example in which the interleaver processes the information bits corresponding to the first RU and the information bits corresponding to the second RU is used for description. In an actual application process, if $N_{RU}$ RUs are allocated to user equipment, a quantity of rows of the interleaver may be a maximum value in quantities of rows of a plurality of conventional interleavers corresponding to the $N_{RU}$ RUs, namely, a maximum value of $x_n \cdot N_{PBSCSn}$, where $n$ is an index of the RU, $N_{RU}$ is a positive integer greater than 1, and $N_{PBSCSn}$ is a modulation order of an $n^{th}$ RU. A quantity of columns of the interleaver may be understood as $\sum_{n=1}^{N_{RU}} N_{COLn}$, and $N_{COLn}$ is a quantity of columns of the conventional interleaver corresponding to an $n^{th}$ RU.

In some embodiments, for a first RU, that is, when an input sequence number k is located in the left matrix block, a sequence number $i_1$ output by the first RU may be shown in Formula 1-4 and Formula 1-5. For meanings of the letters in Formula 1-4 and Formula 1-5, refer to the descriptions in the foregoing content.

$$k_1 = k\text{-}\min(M_2 \cdot \left\lfloor \frac{k}{M_1 + M_2} \right\rfloor, N_2 \cdot M_2) \quad \text{Formula 1-4}$$

$$i_1 = N_1 \cdot (k_1 \bmod M_1) + \left\lfloor \frac{k_1}{M_1} \right\rfloor \quad \text{Formula 1-5}$$

Similarly, for a second RU, that is, when an input sequence number k is located in the right matrix block, a sequence number $i_2$ output by the second RU may be shown in Formula 1-6 and Formula 1-7. For meanings of the letters in Formula 1-6 and Formula 1-7, refer to the descriptions in the foregoing content.

$$k_2 = k\text{-}\min(M_1 \cdot \left\lceil \frac{k}{M_1 + M_2} \right\rceil, N_1 \cdot M_1) \quad \text{Formula 1-6}$$

$$i_2 = N_{\text{ROW}} \cdot ((k \bmod (M_1 + M_2)) - \bmod N_{\text{COL}}) + \left\lfloor \frac{k}{N_{\text{COL}}} \right\rfloor \quad \text{Formula 1-7}$$

The following describes the second interleaver. For a function of the second interleaver, refer to the descriptions of the interleaver 2 in the conventional interleaver in the foregoing content. The second interleaver is configured to receive valid information bits that are output by the first interleaver by column, and perform interleaving mapping on the valid information bits. Then, if a third interleaver exists, processed information bits are input to the third interleaver. If the interleaver does not exist, the processed information bits are input to a bit parser.

The second interleaver is configured to perform interleaving mapping on information bits of a third unit and information bits of a fourth unit. Specifically, the second interleaver is configured to perform interleaving mapping on valid information bits of the third unit based on the modulation order of the first RU. A quantity of columns of the valid information bits of the third unit is $M_1$, and a quantity of rows of the valid information bits of the third unit is $N_1$. The second interleaver is further configured to perform interleaving mapping on valid information bits of the fourth unit based on the modulation order of the second RU. A quantity of columns of the valid information bits of the fourth unit is $M_2$, and a quantity of rows of the valid information bits of the fourth unit is $N_2$. A first column of the information bits of the fourth unit is an $(M_1+1)^{\text{th}}$ column of the second interleaver.

It should be noted that, during actual application, the second interleaver may input and output the information bits of the third unit and the information bits of the fourth unit by using hardware, software, or a combination of software and hardware. In a possible implementation, the second interleaver is implemented by using hardware. The second interleaver may be divided into a first part and a second part. The first part is used to input the information bits of the third unit, and the second part is used to input the information bits of the fourth unit. In another possible implementation, the second interleaver is implemented by using software. The second interleaver determines, in a matrix manner, coordinates of each information bit that can be input by the second interleaver. The second interleaver may determine coordinates of the information bits of the third unit based on a quantity of rows and a quantity of columns of the information bits of the third unit, and determine coordinates of the information bits of the fourth unit based on a quantity of rows and a quantity of columns of the information bits of the fourth unit.

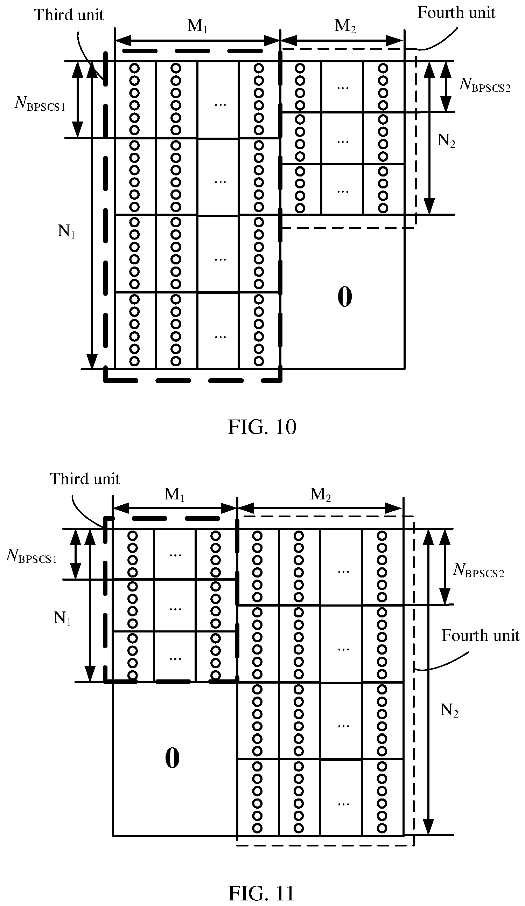

The second interleaver is described by using an example corresponding to the example of the first interleaver described in the foregoing content. FIG. 10 is a schematic diagram of a second interleaver, corresponding to the first interleaver shown in FIG. 8, according to an embodiment of this application. For the third unit and the fourth unit, refer to dashed-line boxes in FIG. 10. The third unit indicates a part occupied by the information bits of the third unit, and the fourth unit indicates a part occupied by the information bits of the fourth unit. The second interleaver is configured to perform interleaving mapping on the valid information bits of the third unit based on the modulation order of the first RU. For an interleaving mapping manner of the second interleaver, refer to the descriptions in the foregoing content. In the example, the modulation order of the first RU is 6, and the second interleaver reorders an order of information bits in every three adjacent information bits of the third unit through downward cyclic shift. The second interleaver is configured to perform interleaving mapping on the valid information bits of the fourth unit based on the modulation order of the second RU. In the example, the modulation order of the second RU is 4, and the second interleaver reorders an order of information bits in every two adjacent information bits of the fourth unit through downward cyclic shift.

FIG. 11 is a schematic diagram of another second interleaver, corresponding to the first interleaver shown in FIG. 9, according to an embodiment of this application. For the third unit and the fourth unit, refer to dashed-line boxes in FIG. 11. The second interleaver is configured to perform interleaving mapping on the valid information bits of the third unit based on the modulation order of the first RU. In the example, the modulation order of the first RU is 4, and the second interleaver reorders an order of information bits in every two adjacent information bits of the third unit through downward cyclic shift. The fourth unit is configured to perform interleaving mapping on the valid information bits of the fourth unit based on the modulation order of the second RU. In the example, the modulation order of the second RU is 6, and the second interleaver reorders an order of information bits in every three adjacent information bits of the fourth unit through downward cyclic shift.

In some embodiments, there is only one spatial data stream on the first RU and the second RU. In this case, the second interleaver is connected to a bit parser. The bit parser is configured to: receive valid information bits output by the second interleaver by column, and output information bits carried on the subcarrier of the first RU and information bits carried on the subcarrier of the second RU. In other words, after being processed by the bit parser, valid information bits output by the second interleaver by column are carried on the subcarrier of the first RU and the subcarrier of the second RU. Specifically, the bit parser first receives the information bits of the third unit, and inputs the information bits to a constellation mapper corresponding to the first RU. Then, the bit parser receives the information bits of the fourth unit, and inputs the information bits to a constellation mapper corresponding to the second RU. It should be noted that invalid information bits need to be discarded and are not input to the constellation mapper.

In some embodiments, there are at least two spatial data streams on the first RU and the second RU. In this case, the interleaver further includes a third interleaver, and the third interleaver is connected to the second interleaver and the bit parser. The third interleaver is configured to receive valid information bits output by the second interleaver by column, and perform frequency rotation on a spatial data stream other than a first spatial data stream in the at least two spatial data streams, and the first spatial data stream is one of the at least two spatial data streams. In a possible implementation, the third interleaver may separately perform frequency rotation on the third unit corresponding to the first RU and the fourth unit corresponding to the second RU. In another possible implementation, the third interleaver may alternatively perform frequency rotation by using a rectangle formed by the entire interleaver as a unit.

The bit parser is configured to: receive valid information bits output by the third interleaver by column, and output information bits carried on the subcarrier of the first RU and information bits carried on the subcarrier of the second RU. In other words, after being processed by the bit parser, valid information bits output by the third interleaver by column are carried on the subcarrier of the first RU and the subcarrier of the second RU. For a manner performed by the bit parser, refer to the descriptions in the foregoing content. Details are not described herein again.

An embodiment of this application further provides another interleaver supporting unequal modulation. The following describes the interleaver.

The interleaver may include a first interleaver and a second interleaver. Specifically, an example in which a first RU and a second RU are allocated to user equipment in which the interleaver is located is used for description. A modulation scheme of the first RU is different from a modulation scheme of the second RU. The interleaver is configured to interleave information bits, to determine an order of information bits carried in a subcarrier of the first RU and a subcarrier of the second RU. It should be noted that for functions of the first interleaver and the second interleaver, refer to the descriptions of the first interleaver supporting unequal modulation in the foregoing content.

The first interleaver is configured to input information bits by row, a quantity of rows of the first interleaver is $i \times (n + m)$, a quantity of columns of the first interleaver is $j/i$, i is a positive integer, n is a modulation order of the first RU, m is a modulation order of the second RU, and j is a larger value in a quantity of subcarriers of the first RU and a quantity of subcarriers of the second RU.

The first interleaver is configured to input information bits of i first units and information bits of i second units by row. A quantity of columns of valid information bits of the first unit is less than or equal to the quantity of columns of the first interleaver, a total quantity of rows of valid information bits of the i first units is $n \times i$, and the valid information bits are bits including an information amount. A quantity of columns of valid information bits of the second unit is less than or equal to the quantity of columns of the first interleaver, and a total quantity of rows of valid information bits of the i second units is $m \times i$.

One first unit is adjacent to one second unit. The first unit indicates a part occupied by the information bits of the first unit, and the first unit indicates a part occupied by the information bits of the second unit. A quantity of rows of the first interleaver corresponding to a first row of information bits of an $a^{th}$ first unit is $(a - 1) \times n + (a - 1) \times m + 1$, and a is a positive integer less than or equal to i. A quantity of rows of the first interleaver corresponding to a first row of information bits of a $b^{th}$ second unit is $b \times n + (b - 1) \times m + 1$, and b is a positive integer less than or equal to i.

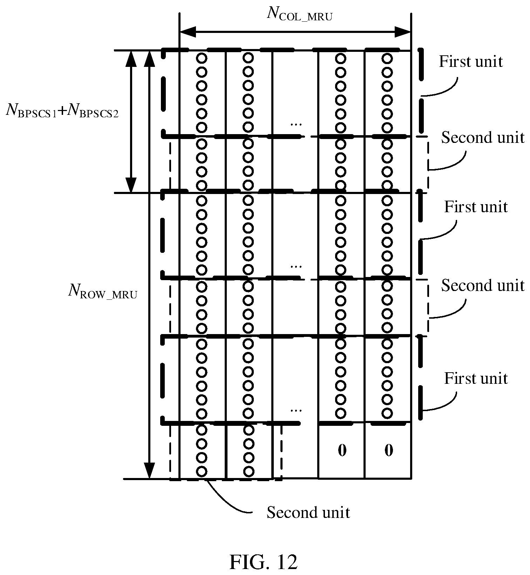

FIG. 12 is a schematic diagram of another first interleaver according to an embodiment of this application. In the example in FIG. 12, $N_{PBSCS1}$ (for example, 6) is a modulation order of the first RU, and $N_{PBSCS2}$ (for example, 4) is a modulation order of the second RU. For the first unit and the second unit, refer to dashed-line boxes in FIG. 12. $N_{COL\_MRU}$ is a quantity of columns of the interleaver, and $N_{ROW\_MRU}$ is a quantity of rows of the interleaver. Specifically, the first interleaver includes three first units and three second units, and one first unit is adjacent to one second unit. A first row of information bits of a first first unit is a first row of the first interleaver, a first row of information bits of a second first unit is a (1 × 6 + 1 × 4 + 1 = 11)$^{th}$ row of the first interleaver, and a first row of information bits of a third first unit is a (2 × 6 + 2 × 4 + 1 = 21)$^{th}$ row of the first interleaver. In addition, a quantity of columns of the information bits of the first first unit, a quantity of columns of the information bits of the second first unit, and a quantity of columns of the information bits of the third first unit are all the same as the quantity of columns of the first interleaver. A first row of information bits of a first second unit is a (1 × 6 + 1 = 7)$^{th}$ row of the first interleaver, a first row of information bits of a second second unit is a (2 × 6 + 1 × 4 + 1 = 17)$^{th}$ row of the first interleaver, and a first row of information bits of a third second unit is a (3 × 6 + 2 × 4 + 1 = 27)$^{th}$ row of the first interleaver.

In addition, a quantity of columns of valid information bits of the first second unit, a quantity of columns of valid information bits of the second second unit, and a quantity of columns of valid information bits of the third second unit are less than the quantity of columns of the first interleaver. The quantity of columns of the valid information bits of the third first unit is less than the quantity of columns of the first interleaver because the quantity of subcarriers of the second RU is less than the quantity of subcarriers of the first RU. It may be understood that a total quantity of the valid information bits of the i first units is a total quantity of information bits included in the conventional interleaver corresponding to the first RU, and a total quantity of the valid information bits of the i second units is a total quantity of information bits included in the conventional interleaver corresponding to the second RU. A part that cannot be filled with the information bits of the first interleaver may be filled with invalid information bits, and the bits may be 0. In this case, the quantity of columns of the information bits of the third first unit is equal to the quantity of columns of the first interleaver, but the quantity of columns of the valid information bits of the third first unit is less than the quantity of columns of the first interleaver. Alternatively, the part is null, and does not include any information bit. A manner shown in FIG. 12 corresponds to unused subcarriers by row. In other words, the information bits of the second unit are preferentially filled with rows.

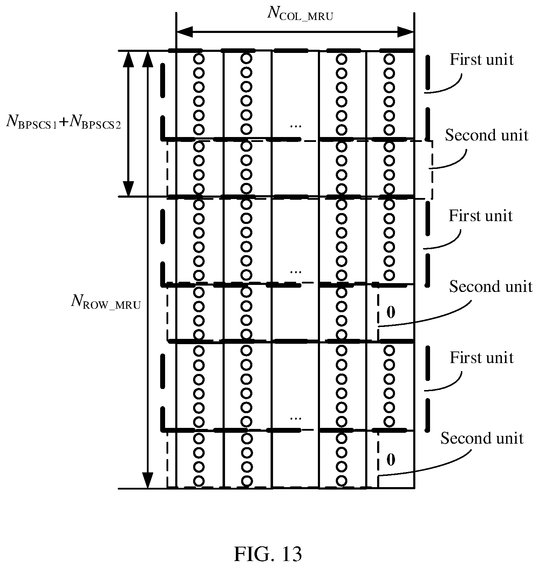

In some embodiments, the manner may correspond to unused subcarriers by column. In other words, the information bits of the second unit are preferentially filled with columns. For the manner, refer to FIG. 13. FIG. 13 is a schematic diagram of another first interleaver according to an embodiment of this application. In the example in FIG. 13, a quantity of columns of valid information bits of a first second unit is the same as a quantity of columns of the first interleaver, and a quantity of columns of valid information bits of a second second unit and a quantity of columns of valid information bits of a second unit are less than the quantity of columns of the first interleaver.

The following describes a second interleaver in the interleaver. The second interleaver is configured to receive information bits that are output by the first interleaver by column, and perform interleaving mapping on the information bits. Then, if a third interleaver exists, processed information bits are input to the third interleaver. If the interleaver does not exist, the processed information bits are input to a bit parser.

The second interleaver is configured to perform interleaving mapping on information bits of i third units and information bits of i fourth units. Specifically, the second interleaver is configured to perform interleaving mapping on valid information bits of the third unit based on the modulation order of the first RU, a quantity of columns of the valid information bits of the third unit is less than or equal to the quantity of columns of the first interleaver, a total quantity of rows of valid information bits of the i third units is n × i, and the valid information bits are bits including an information amount. The second interleaver is configured to perform interleaving mapping on valid information bits of the fourth unit based on the modulation order of the second RU, a quantity of columns of the valid information bits of the fourth unit is less than or equal to the quantity of columns of the first interleaver, and a total quantity of rows of valid information bits of the i fourth units is m × i. For an interleaving mapping manner of the second interleaver, refer to the descriptions in the foregoing content.

One third unit is adjacent to one fourth unit. The third unit indicates a part occupied by the information bits of the third unit, and the fourth unit indicates a part occupied by the information bits of the fourth unit. Specifically, a quantity of rows of the second interleaver corresponding to a first row of information bits of a c$^{th}$ third unit is (c - 1) × n + (c - 1) × m + 1, and c is a positive integer less than or equal to i. A quantity of rows of the second interleaver corresponding to a first row of information bits of a d$^{th}$ fourth unit is d × n + (d - 1) × m + 1, and d is a positive integer less than or equal to i.

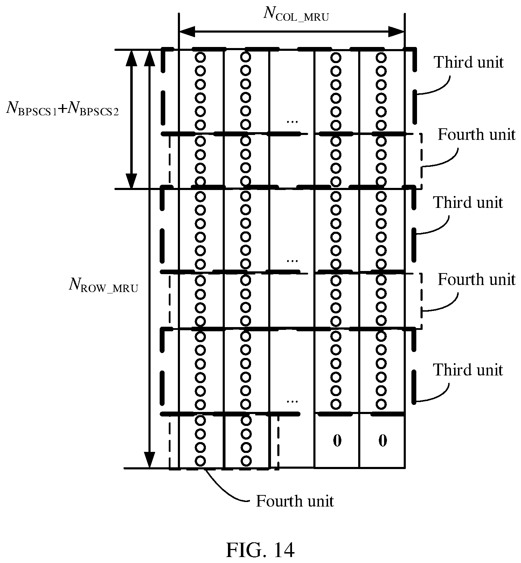

The second interleaver is described by using an example corresponding to the example of the first interleaver described in the foregoing content. FIG. 14 is a schematic diagram of a second interleaver, corresponding to the first interleaver shown in FIG. 12, according to an embodiment of this application. For the third unit and the fourth unit, refer to dashed-line boxes in FIG. 14. The second interleaver is configured to perform interleaving mapping on the valid information bits of the third unit based on the modulation order of the first RU. For an interleaving mapping manner of the second interleaver, refer to the descriptions in the foregoing content. In the example, the modulation order of the first RU is 6, and the second interleaver reorders an order of information bits in every three adjacent information bits of the third unit through downward cyclic shift. The fourth unit is configured to perform interleaving mapping on the valid information bits of the fourth unit based on the modulation order of the second RU. In the example, the modulation order of the second RU is 4, and the second interleaver reorders an order of information bits in every two adjacent information bits of the fourth unit through downward cyclic shift.

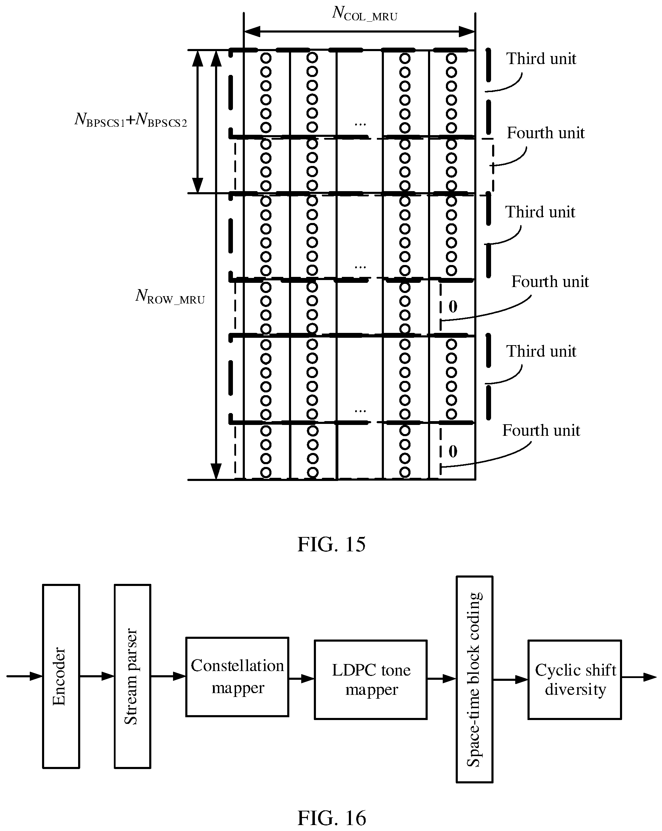

FIG. 15 is a schematic diagram of another second interleaver, corresponding to the first interleaver shown in FIG.

13, according to an embodiment of this application. For the third unit and the fourth unit, refer to dashed-line boxes in FIG. 15. The second interleaver is configured to perform interleaving mapping on the valid information bits of the third unit based on the modulation order of the first RU. In the example, the modulation order of the first RU is 6, and the second interleaver reorders an order of information bits in every three adjacent information bits of the third unit through downward cyclic shift. The fourth unit is configured to perform interleaving mapping on the valid information bits of the fourth unit based on the modulation order of the second RU. In the example, the modulation order of the second RU is 4, and the second interleaver reorders an order of information bits in every two adjacent information bits of the fourth unit through downward cyclic shift.

In some embodiments, there is only one spatial data stream on the first RU and the second RU. In this case, the second interleaver is connected to a bit parser. The bit parser is configured to: receive valid information bits output by the second interleaver by column, and sequentially output first information bits in a unit of n bits and second information bits in a unit of m bits. In other words, after being processed by the bit parser, valid information bits that are output by the second interleaver by column are sequentially output as the first information bits in a unit of n bits and the second information bits in a unit of m bits. The first information bits are information bits carried on the subcarrier of the first RU, and the second information bits are information bits carried on the subcarrier of the second RU. Because the first unit is adjacent to the second unit, the bit parser cyclically outputs the first information bits in a unit of n bits and the second information bits in a unit of m bits in sequence. Specifically, the bit parser inputs the first information bits in a unit of n bits to a constellation mapper corresponding to the first RU, and inputs the second information bits in a unit of m bits to a constellation mapper corresponding to the second RU. It should be noted that invalid information bits need to be discarded and are not input to the constellation mapper.

In some other embodiments, there are at least two spatial data streams on the first RU and the second RU. In this case, the interleaver further includes a third interleaver, and the third interleaver is connected to the second interleaver and the bit parser. The third interleaver is configured to receive valid information bits output by the second interleaver by column, and perform frequency rotation on a spatial data stream other than a first spatial data stream in the at least two spatial data streams, and the first spatial data stream is one of the at least two spatial data streams. In a possible implementation, the third interleaver may separately perform frequency rotation on the third unit corresponding to the first RU and the fourth unit corresponding to the second RU. In another possible implementation, the third interleaver may alternatively perform frequency rotation by using a rectangle formed by the entire interleaver as a unit.

The bit parser is configured to: receive valid information bits output by the third interleaver by column, and sequentially output first information bits in a unit of n bits and second information bits in a unit of m bits. In other words, after being processed by the bit parser, valid information bits that are output by the third interleaver by column are sequentially output as the first information bits in a unit of n bits and the second information bits in a unit of m bits. For a manner performed by the bit parser, refer to the descriptions in the foregoing content. Details are not described herein again.

The foregoing describes the interleaver supporting unequal modulation. The following describes a subcarrier mapper supporting unequal modulation.

In a possible implementation, a WLAN communication system may further support a low-density parity-check (Low-Density Parity-Check, LDPC) coding scheme. FIG. 16 is a schematic diagram of another system implementing BICM according to an embodiment of this application. The system includes an encoder, a stream parser, a constellation mapper, and an LDPC tone mapper. The encoder is configured to encode a bit stream or data, and convert the bit stream or the data into a signal form (for example, a data stream) that can be used for communication, transmission, and storage. For example, the encoder may be an LDPC encoder. The stream parser is configured to allocate encoded information bits to different data streams. For a data stream, the stream parser may intercept information bits based on a quantity of subcarriers and a modulation order that correspond to an allocated RU, and then input the information bits to the constellation mapper. The constellation mapper is configured to map the information bits to the subcarrier based on the modulation order of the RU. Then, the LDPC tone mapper may distribute the subcarriers, and change a sequence of the subcarriers, to avoid strings of bit errors. This can improve information transmission reliability. Then, space-time block coding, cyclic shift diversity processing, and the like are performed on the subcarriers. In the BICM system, a diversity gain may be increased by using the LDPC tone mapper, to effectively improve system transmission reliability.

For example, it is assumed that each of n OFDM symbols includes $N_{SD}$ valid (or referred to as data) subcarriers, where n is an index of the OFDM symbol $(_{SYM})$, and $l$ is an index of $N_{SS}$ streams. An input of the LDPC tone mapper is $d_{k,l,n}$, and an output of the LDPC tone mapper is $d'_{k,l,n}$. An LDPC tone mapping manner is shown in Formula 1-8.

$$d'_{k,l,n} = d_{t(k),l,n} \quad \text{1-8}$$

$$t(k) = D_{TM} \cdot \left(k \bmod \frac{N_{SD}}{D_{TM}}\right) + \left\lfloor \frac{k \cdot D_{TM} N_{SD}}{N_{SD}} \right\rfloor, k = 0, 1, \dots, N_{SD} - 1, l = 0, 1, \dots, N_{SS} - 1, n = 0, 1, \dots, N_{SYM} - 1, N_{SD}$$ (Number of data subcarriers) is a quantity of valid subcarriers, and $D_{TM}$ is an LDPC tone mapping distance parameter (LDPC tone mapping distance parameter).

When a plurality of RUs may be allocated to one user, different modulation and coding schemes may be configured for the plurality of RUs of the same user. Currently, one LDPC tone mapper only processes an RU using only one modulation scheme. Information bits of each of the plurality of RUs are processed by using a single LDPC tone mapper, to process information bits of the plurality of RUs using different MCSs.

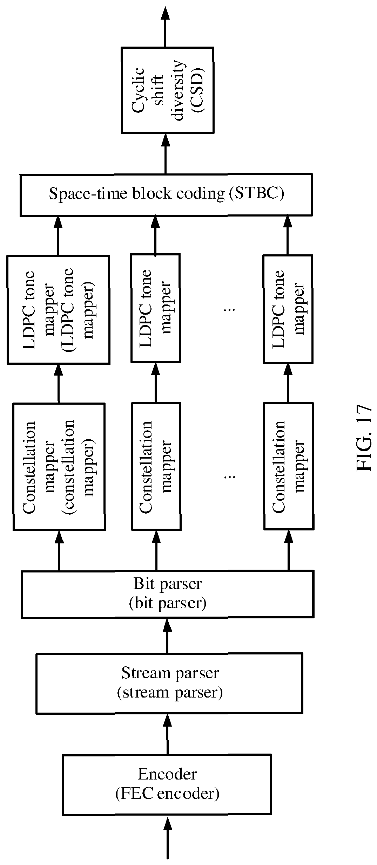

FIG. 17 is a schematic diagram of a processing system according to an embodiment of this application. The figure includes two levels of processing units. A first-level processing unit allocates information bits in an interleaving manner based on different RUs of a user by using a bit parser, and a second-level processing unit processes subcarriers corresponding to the RUs by using a plurality of constellation mappers and a plurality of LDPC tone mappers. In this manner, a plurality of LDPC tone mappers need to be designed for different RUs allocated to a single user. One LDPC tone mapper corresponds to one RU, and one LDPC tone mapper supports an MCS of a corresponding RU. In other words, UEQM with a plurality of RUs can be implemented. For a user, in this manner, user equipment needs to support a plurality of LDPC tone mappers in parallel, and hardware costs are high.

With reference to the data communication system, the STA, and the AP described in the foregoing content, the following describes an LDPC tone mapper supporting unequal modulation provided in embodiments of this application. The method may be implemented based on the data communication system shown in FIG. 1. A communication device using the LDPC tone mapper may be the STA or the AP in the data communication system shown in FIG. 1. Information processed by the LDPC tone mapper may be transmitted between STAs, between APs, and between the STA and the AP. In another possible implementation, a communication device using the LDPC tone mapper may alternatively be a multi-link device (multi-link device, MLD).

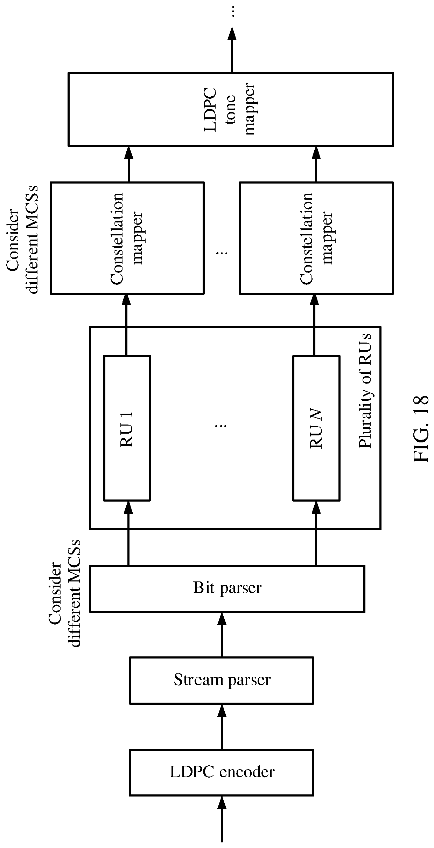

First, the following describes a system that implements BICM and to which the LDPC tone mapper in embodiments of this application is applied. FIG. 18 is a schematic diagram of another system implementing BICM according to an embodiment of this application. The system includes apparatus such as an LDPC encoder, a stream parser, a bit parser, a constellation mapper, and an LDPC tone mapper. The LDPC encoder is configured to encode a bit stream or data by using an LDPC coding manner, and convert the bit stream or the data into a signal form (for example, a data stream) that can be used for communication, transmission, and storage. The stream parser is configured to divide a data stream. The bit parser is configured to distribute a stream of information bits on a plurality of RUs and input the stream of information bits to the constellation mapper. When the interleaver supports UEQM, the modules need to consider different modulation schemes of the RUs. For example, the bit parser needs to consider a quantity of subcarriers and a modulation order of the RU, and the constellation mapper also needs to consider changing of the modulation order caused by different MCSs. For example, when a modulation order is 4, every four information bits are mapped to one constellation point. When the modulation order is 6, every six information bits are mapped to one constellation point. In addition, constellation mappers in parallel in the foregoing figure may alternatively be changed to a unified constellation mapper, to reduce device complexity.

The following further describes the LDPC tone mapper in embodiments of this application. Specifically, an example in which a first RU, a second RU, and a third RU are allocated to user equipment in which the LDPC tone mapper is located is used for description. A modulation scheme of the first RU is the same as a modulation scheme of the second RU, and the modulation scheme of the first RU is different from a modulation scheme of the third RU. The subcarrier mapper is configured to map subcarriers of the first RU, the second RU, and the third RU.

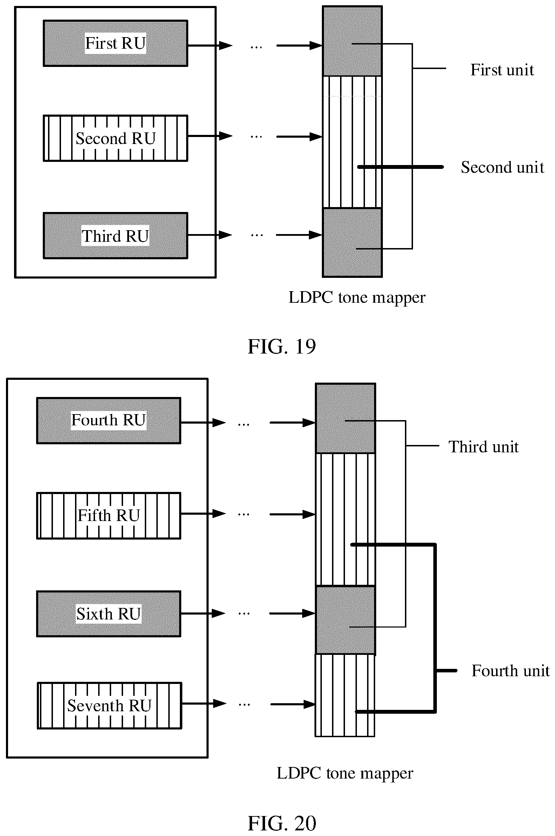

FIG. 19 is a schematic diagram of an LDPC tone mapper according to an embodiment of this application. The LDPC tone mapper includes a first unit and a second unit. The first unit is configured to map the subcarrier of the first RU and the subcarrier of the second RU based on the modulation scheme of the first RU. The second unit is configured to map the subcarrier of the third RU based on the modulation scheme of the third RU. It should be noted that subcarrier mapping may be performed between the subcarrier of the first RU and the subcarrier of the second RU, and subcarrier mapping is performed inside the subcarrier of the third RU. For a mapping manner, refer to the descriptions in the foregoing content.

It should be noted that, during actual application, the LDPC tone mapper may process the first unit and the second unit by using hardware, software, or a combination of software and hardware. In a possible implementation, the LDPC tone mapper is implemented by using hardware. The LDPC tone mapper may include a first unit and a second unit. The first unit maps the subcarrier of the first RU and the subcarrier of the second RU based on the modulation scheme of the first RU. The second unit maps the subcarrier of the third RU based on the modulation scheme of the third RU. In another possible implementation, the LDPC tone mapper is implemented by using software. The LDPC tone mapper determines, in a matrix manner, coordinates of each subcarrier that can be input by the LDPC tone mapper. The first unit processes the subcarrier of the first RU and the subcarrier of the second RU based on coordinates of the subcarrier of the first RU and coordinates of the subcarrier of the second RU and the modulation scheme of the first RU. The second unit processes the subcarrier of the third RU based on coordinates of the subcarrier of the third RU and the modulation scheme of the third RU.

In another example, an example in which a fourth RU, a fifth RU, a sixth RU, and a seventh RU are allocated to user equipment in which the LDPC tone mapper is located is used for description. A modulation scheme of the fourth RU is the same as a modulation scheme of the sixth RU, a modulation scheme of the fifth RU is the same as a modulation scheme of the seventh RU, and the modulation scheme of the fourth RU is different from the modulation scheme of the fifth RU. The subcarrier mapper is configured to map subcarriers of the fourth RU, the fifth RU, the sixth RU, and the seventh RU.

FIG. 20 is a schematic diagram of another LDPC tone mapper according to an embodiment of this application. The LDPC tone mapper includes a third unit and a fourth unit. The third unit is configured to map the subcarrier of the fourth RU and the subcarrier of the sixth RU based on the modulation scheme of the fourth RU, and the fourth unit is configured to map the subcarrier of the fifth RU and the subcarrier of the seventh RU based on the modulation scheme of the fifth RU. It should be noted that subcarrier mapping may be performed between the subcarrier of the fourth RU and the subcarrier of the sixth RU, and subcarrier mapping may be performed between the subcarrier of the fifth RU and the subcarrier of the seventh RU.

In other words, in the LDPC tone mapper, LDPC tone mapping is performed between subcarriers of RUs using a same modulation scheme, and subcarrier mapping is not performed between subcarriers of RUs using different modulation schemes. In the LDPC tone mapper, subcarrier mapping is performed between subcarriers of RUs using a same modulation scheme, to increase a subcarrier distribution range, and improve a diversity gain. It should be noted that subcarriers of two RUs using a same modulation scheme but with different code rates may still be combined together for subcarrier mapping. In other words, the manner limits only the modulation scheme.

With reference to various apparatuses described in the foregoing content, the following describes an interleaving method and a subcarrier mapping method supporting unequal modulation provided in embodiments of this application.

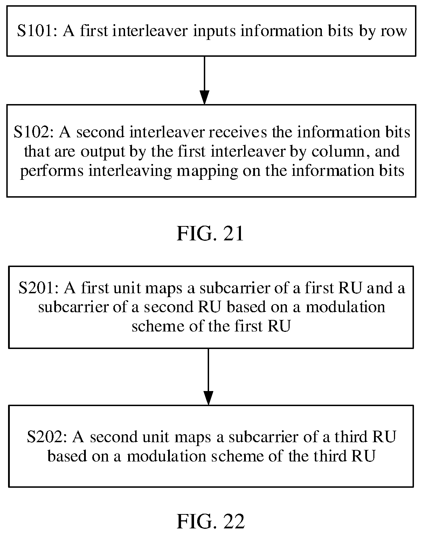

FIG. 21 is a schematic flowchart of an interleaving method supporting unequal modulation according to an embodiment of this application. The method is applied to an interleaver, the interleaver includes a first interleaver and a second interleaver, the interleaver is configured to interleave information bits, to determine an order of information bits carried in a subcarrier of a first RU and a subcarrier of a second RU, and a modulation scheme of the first RU is different from a modulation scheme of the second RU. The method includes the following steps.

S101: The first interleaver inputs information bits by row.

S102: The second interleaver receives the information bits that are output by the first interleaver by column, and performs interleaving mapping on the information bits.

In an implementation, a quantity of columns of the first interleaver is $M_1+M_2$, and a quantity of rows of the first interleaver is a larger value in $N_1$ and $N_2$. $N_1$ is a quantity of rows determined based on a quantity of subcarriers of the first RU, $M_1$ is a quantity of columns determined based on the quantity of subcarriers of the first RU, $N_2$ is a quantity of rows determined based on a quantity of subcarriers of the second RU, $M_2$ is a quantity of columns determined based on the quantity of subcarriers of the second RU, and $N_1$, $M_1$, $N_2$, and $M_2$ are positive integers.

In some embodiments, that the first interleaver inputs information bits by row includes: The first interleaver inputs information bits of a first unit and information bits of a second unit by row. A quantity of columns of valid information bits of the first unit is $M_1+M_2$, a quantity of rows of the valid information bits of the first unit is a smaller value in $N_1$ and $N_2$, and the valid information bits are bits including an information amount. A quantity of columns of valid information bits of the second unit is $M_1$ or $M_2$, and a quantity of rows of the valid information bits of the second unit is an absolute value of a difference between $N_1$ and $N_2$. A first row of the information bits of the second unit is an $(N_2+1)^{th}$ row of the first interleaver, and a first column of the information bits of the second unit is a first column of the interleaver; or a first row of the information bits of the second unit is an $(N_1+1)^{th}$ row of the first interleaver, and a first column of the information bits of the second unit is an $(M_1+1)^{th}$ column of the first interleaver.

In some embodiments, that the second interleaver performs interleaving mapping on the information bits includes: The second interleaver performs interleaving mapping on information bits of a third unit and information bits of a fourth unit. That the second interleaver performs interleaving mapping on information bits of a third unit includes: The second interleaver performs interleaving mapping on valid information bits of the third unit based on a modulation order of the first RU. A quantity of columns of the valid information bits of the third unit is $M_1$, a quantity of rows of the valid information bits of the third unit is $N_1$, and the valid information bits are bits including an information amount. That the second interleaver performs interleaving mapping on information bits of a fourth unit includes: The second interleaver performs interleaving mapping on valid information bits of the fourth unit based on a modulation order of the second RU. A quantity of columns of the valid information bits of the fourth unit is $M_2$, and a quantity of rows of the valid information bits of the fourth unit is $N_2$. A first column of the information bits of the fourth unit is an $(M_1+1)^{th}$ column of the second interleaver.

In some embodiments, there is only one spatial data stream on the first RU and the second RU, after being processed through bit parsing, valid information bits output by the second interleaver by column are carried on the subcarrier of the first RU and the subcarrier of the second RU, and the valid information bits are bits including an information amount.

In some embodiments, there are at least two spatial data streams on the first RU and the second RU, and the interleaver further includes a third interleaver. The method further includes: The third interleaver receives valid information bits output by the second interleaver by column, and performs frequency rotation on a spatial data stream other than a first spatial data stream in the at least two spatial data streams. The first spatial data stream is one of the at least two spatial data streams, and the valid information bits are bits including an information amount. After being processed through bit parsing, valid information bits output by the third interleaver by column are carried on the subcarrier of the first RU and the subcarrier of the second RU. Optionally, the valid information bits output by the third interleaver by column may be processed by a bit parser connected to the third interleaver.

For implementations of steps in this embodiment, refer to the descriptions in the foregoing content. For the interleaver, refer to the descriptions of the first interleaver in the foregoing content.

In another implementation, a quantity of rows of the first interleaver is $i \times (n + m)$, a quantity of columns of the first interleaver is $j/i$, i is a positive integer, n is a modulation order of the first RU, m is a modulation order of the second RU, and j is a larger value in a quantity of subcarriers of the first RU and a quantity of subcarriers of the second RU.

In some embodiments, that the first interleaver inputs information bits by row includes: The first interleaver inputs information bits of i first units and information bits of i second units by row. A quantity of columns of valid information bits of the first unit is less than or equal to the quantity of columns of the first interleaver, a total quantity of rows of valid information bits of the i first units is $n \times i$, and the valid information bits are bits including an information amount. A quantity of columns of valid information bits of the second unit is less than or equal to the quantity of columns of the first interleaver, and a total quantity of rows of valid information bits of the i second units is $m \times i$. A quantity of rows of the first interleaver corresponding to a first row of information bits of an $a^{th}$ first unit is $(a - 1) \times n + (a - 1) \times m + 1$, and a is a positive integer less than or equal to i. A quantity of rows of the first interleaver corresponding to a first row of information bits of a $b^{th}$ second unit is $b \times n + (b - 1) \times m + 1$, and b is a positive integer less than or equal to i.

In some embodiments, that the second interleaver performs interleaving mapping on the information bits includes: The second interleaver performs interleaving mapping on information bits of i third units and information bits of i fourth units. That the second interleaver performs interleaving mapping on information bits of i third units includes: The second interleaver performs interleaving mapping on valid information bits of the third unit based on the modulation order of the first RU, a quantity of columns of the valid information bits of the third unit is less than or equal to the quantity of columns of the first interleaver, a total quantity of rows of valid information bits of the i third units is $n \times i$, and the valid information bits are bits including an information amount. That the second interleaver performs interleaving mapping on information bits of i fourth units includes: The second interleaver performs interleaving mapping on valid information bits of the fourth unit based on the modulation order of the second RU, a quantity of columns of the valid information bits of the fourth unit is less than or equal to the quantity of columns of the first interleaver, and a total quantity of rows of valid information bits of the i fourth units is $m \times i$. A quantity of rows of the second interleaver corresponding to a first row of information bits of a $c^{th}$ third unit is $(c - 1) \times n + (c - 1) \times m + 1$, and c is a positive integer less than or equal to i. A quantity of rows of the second interleaver corresponding to a first row of information bits of a $d^{th}$ fourth unit is $d \times n + (d - 1) \times m + 1$, and d is a positive integer less than or equal to i.

In some embodiments, there is only one spatial data stream on the first RU and the second RU. After being processed through bit parsing, valid information bits output by the second interleaver by column are sequentially output as first information bits in a unit of n bits and second information bits in a unit of m bits, the first information bits are information bits carried on the subcarrier of the first RU, and the second information bits are information bits carried on the subcarrier of the second RU.

In some embodiments, there are at least two spatial data streams on the first RU and the second RU. The method further includes: A third interleaver receives valid information bits output by the second interleaver by column, and performs frequency rotation on a spatial data stream other than a first spatial data stream in the at least two spatial data streams. The first spatial data stream is one of the at least two spatial data streams. After being processed through bit parsing, valid information bits output by the third interleaver by column are sequentially output as first information bits in a unit of n bits and second information bits in a unit of m bits, the first information bits are information bits carried on the subcarrier of the first RU, and the second information bits are information bits carried on the subcarrier of the second RU.

For implementations of steps in this embodiment, refer to the descriptions in the foregoing content. For the interleaver, refer to the descriptions of the second interleaver in the foregoing content.

In the interleaving method shown in FIG. 21, a unified interleaver may interleave information bits of a plurality of RUs using different modulation and coding schemes, to simplify a hardware structure of a communication apparatus, and reduce hardware costs.

FIG. 22 shows a subcarrier mapping method supporting unequal modulation according to an embodiment of this application not encompassed by the wording of the claims. The method is applied to a subcarrier mapper, the subcarrier mapper includes a first unit and a second unit, the subcarrier mapper is configured to map subcarriers of a first RU, a second RU, and a third RU, a modulation scheme of the first RU is the same as a modulation scheme of the second RU, and the modulation scheme of the first RU is different from a modulation scheme of the third RU. The method includes the following steps.

S201: The first unit maps the subcarrier of the first RU and the subcarrier of the second RU based on the modulation scheme of the first RU.

S202: The second unit maps the subcarrier of the third RU based on the modulation scheme of the third RU.

For implementations of steps in this embodiment, refer to the descriptions in the foregoing content. For the subcarrier mapper, refer to the descriptions of the subcarrier mapper in the foregoing content.

In the subcarrier mapping method shown in FIG. 22, a unified subcarrier mapper may map subcarriers of a plurality of RUs, to simplify a hardware structure of a communication apparatus, and reduce hardware costs.

A person skilled in the art may further understand that various illustrative logical blocks (illustrative logical block) and steps (step) that are listed in embodiments of this application may be implemented by using electronic hardware, computer software, or a combination thereof. Whether the functions are implemented by using hardware or software depends on particular applications and a design requirement of the entire system. A person skilled in the art may use various methods to implement the described functions for each particular application, but it should not be considered that the implementation goes beyond the scope of embodiments of this application.

This application further provides a computer-readable storage medium. The computer-readable storage medium stores a computer program. When the computer-readable storage medium is executed by a computer, functions of any one of the method embodiments are implemented.

This application further provides a computer program product. When the computer program product is executed by a computer, functions of any one of the method embodiments are implemented.

All or some of the embodiments may be implemented by using software, hardware, firmware, or any combination thereof. When the software is used to implement the embodiments, all or some of the embodiments may be implemented in a form of a computer program product. The computer program product includes one or more computer instructions. When the computer instructions are loaded and executed on the computer, the procedures or functions according to embodiments of this application are all or partially generated. The computer may be a general-purpose computer, a special-purpose computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a high-density digital video disc (digital video disc, DVD)), a semiconductor medium (for example, a solid-state disk (solid-state disk, SSD)), or the like.

A person of ordinary skill in the art may understand that various numerals such as "first" and "second" in this application are merely used for differentiation for ease of description, and are not used to limit the scope or a sequence of embodiments of this application.

The correspondences shown in the tables in this application may be configured, or may be predefined. Values of the information in the tables are merely examples, and other values may be configured. This is not limited in this application. When a correspondence between information and each parameter is configured, not all correspondences shown in the tables need to be configured. For example, in the tables in this application, correspondences shown in some rows may alternatively not be configured. For another example, proper deformations and adjustments such as splitting and combination may be performed based on the foregoing tables. Names of the parameters shown in titles of the foregoing tables may alternatively be other names that can be understood by a communication apparatus, and values or representation manners of the parameters may alternatively be other values or representation manners that can be understood by the communication apparatus. During implementation of the foregoing tables, another data structure, such as an array, a queue, a container, a stack, a linear table, a pointer, a linked list, a tree, a graph, a structure, a class, a pile, or a hash table, may alternatively be used.

"Predefine" in this application may be understood as "define", "predefine", "store", "pre-store", "pre-negotiate", "pre-configure", "build into", or "pre-burn".

A person of ordinary skill in the art may be aware that, with reference to the examples described in embodiments disclosed in this specification, units and algorithm steps may be implemented by electronic hardware or a combination of computer software and electronic hardware. Whether the functions are executed by hardware or software depends on particular applications and design constraints of the technical solutions. A person skilled in the art may use different methods to implement the described functions for each particular application, but it should not be considered that the implementation goes beyond the scope of this application.

A person skilled in the art may clearly understand that, for the purpose of convenient and brief description, for a detailed working process of the foregoing system, apparatus, and unit, refer to a corresponding process in the method embodiments. Details are not described herein again.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

**Claims**

1. An interleaver supporting unequal modulation, wherein the interleaver comprises a first interleaver and a second interleaver, the interleaver is configured to interleave information bits, to determine an order of information bits carried in a subcarrier of a first resource unit, RU, and a subcarrier of a second RU, and a modulation scheme of the first RU is different from a modulation scheme of the second RU;

the first interleaver is configured to input information bits by row, a quantity of columns of the first interleaver is $M_1 + M_2$, a quantity of rows of the first interleaver is a larger value in $N_1$ and $N_2$, $N_1$ is a quantity of rows determined based on a quantity of subcarriers of the first RU, $M_1$ is a quantity of columns determined based on the quantity of subcarriers of the first RU, $N_2$ is a quantity of rows determined based on a quantity of subcarriers of the second RU, $M_2$ is a quantity of columns determined based on the quantity of subcarriers of the second RU, and $N_1$, $M_1$, $N_2$, and $M_2$ are positive integers; wherein $N_1 = x \cdot N_{BPSCS,1}$ and $x \cdot M_1 = N_{SD,1}$, $N_{BPSCS,1}$ is a modulation order of the first RU, $N_{SD,1}$ is a quantity of data subcarriers of the first RU; $N_2 = x \cdot N_{BPSCS,2}$ and $x \cdot M_2 = N_{SD,2}$, $N_{BPSCS,2}$ is a modulation order of the second RU, $N_{SD,2}$ is a quantity of data subcarriers of the second RU, $x$ is a positive integer; and
the second interleaver is configured to receive the information bits that are output by the first interleaver by column, and perform interleaving mapping on the information bits received from the first interleaver.

2. The interleaver according to claim 1, wherein the first interleaver is configured to input information bits of a first unit and information bits of a second unit by row;

a quantity of columns of valid information bits of the first unit is $M_1 + M_2$, a quantity of rows of the valid information bits of the first unit is a smaller value in $N_1$ and $N_2$, and the valid information bits are bits comprising an information amount, the valid information bits are information bits that are encoded by an encoder and actually input to the interleaver, and then are carried on subcarriers;
a quantity of columns of valid information bits of the second unit is $M_1$ or $M_2$, and a quantity of rows of the valid information bits of the second unit is an absolute value of a difference between $N_1$ and $N_2$; and
a first row of the information bits of the second unit is an $(N_2+1)^{th}$ row of the first interleaver, and a first column of the information bits of the second unit is a first column of the interleaver; or a first row of the information bits of the second unit is an $(N_1+1)^{th}$ row of the first interleaver, and a first column of the information bits of the second unit is an $(M_1+1)^{th}$ column of the first interleaver.

3. The interleaver according to claim 1 or 2, wherein the second interleaver is configured to perform interleaving mapping on information bits of a third unit and information bits of a fourth unit;

the second interleaver is configured to perform interleaving mapping on valid information bits of the third unit based on a modulation order of the first RU, a quantity of columns of the valid information bits of the third unit is $M_1$, a quantity of rows of the valid information bits of the third unit is $N_1$, and the valid information bits are bits comprising an information amount, the valid information bits are information bits that are encoded by an encoder and actually input to the interleaver, and then are carried on subcarriers;
the second interleaver is configured to perform interleaving mapping on valid information bits of the fourth unit based on a modulation order of the second RU, a quantity of columns of the valid information bits of the fourth unit is $M_2$, and a quantity of rows of the valid information bits of the fourth unit is $N_2$; and
a first column of the information bits of the fourth unit is an $(M_1+1)^{th}$ column of the second interleaver.

4. The interleaver according to any one of claims 1 to 3, wherein there is only one spatial data stream on the first RU and the second RU, the second interleaver is connected to a bit parser, after being processed by the bit parser, valid information bits output by the second interleaver by column are carried on the subcarrier of the first RU and the subcarrier of the second RU, and the valid information bits are bits comprising an information amount, the valid information bits are information bits that are encoded by an encoder and actually input to the interleaver, and then are carried on subcarriers.

5. The interleaver according to any one of claims 1 to 3, wherein there are at least two spatial data streams on the first RU and the second RU, the interleaver further comprises a third interleaver, and the third interleaver is connected to the second interleaver and a bit parser;

the third interleaver is configured to receive valid information bits output by the second interleaver by column, and perform frequency rotation on a spatial data stream other than a first spatial data stream in the at least two spatial data streams, the first spatial data stream is one of the at least two spatial data streams, and the valid information bits are bits comprising an information amount, the valid information bits are information bits that are encoded by an encoder and actually input to the interleaver, and then are carried on subcarriers; and

after being processed by the bit parser, valid information bits output by the third interleaver by column are carried on the subcarrier of the first RU and the subcarrier of the second RU.

6. An interleaver supporting unequal modulation, wherein the interleaver comprises a first interleaver and a second interleaver, the interleaver is configured to interleave information bits, to determine an order of information bits carried in a subcarrier of a first resource unit, RU, and a subcarrier of a second RU, and a modulation scheme of the first RU is different from a modulation scheme of the second RU;

the first interleaver is configured to input information bits by row, a quantity of rows of the first interleaver is $i \times (n + m)$, a quantity of columns of the first interleaver is $j/i$, i is a positive integer, n is a modulation order of the first RU, m is a modulation order of the second RU, and j is a larger value in a quantity of subcarriers of the first RU and a quantity of subcarriers of the second RU; and
the second interleaver is configured to receive the information bits that are output by the first interleaver by column, and perform interleaving mapping on the information bits received from the first interleaver.

7. The interleaver according to claim 6, wherein the first interleaver is configured to input information bits of i first units and information bits of i second units by row;

a quantity of columns of valid information bits of the first unit is less than or equal to the quantity of columns of the first interleaver, a total quantity of rows of valid information bits of the i first units is $n \times i$, and the valid information bits are bits comprising an information amount, the valid information bits are information bits that are encoded by an encoder and actually input to the interleaver, and then are carried on subcarriers;
a quantity of columns of valid information bits of the second unit is less than or equal to the quantity of columns of the first interleaver, and a total quantity of rows of valid information bits of the i second units is $m \times i$;
a quantity of rows of the first interleaver corresponding to a first row of information bits of an $a^{th}$ first unit is $(a - 1) \times n + (a - 1) \times m + 1$, and a is a positive integer less than or equal to i; and
a quantity of rows of the first interleaver corresponding to a first row of information bits of a $b^{th}$ second unit is $b \times n + (b - 1) \times m + 1$, and b is a positive integer less than or equal to i.

8. The interleaver according to claim 6 or 7, wherein the second interleaver is configured to perform interleaving mapping on information bits of i third units and information bits of i fourth units;

the second interleaver is configured to perform interleaving mapping on valid information bits of the third unit based on the modulation order of the first RU, a quantity of columns of the valid information bits of the third unit is less than or equal to the quantity of columns of the first interleaver, a total quantity of rows of valid information bits of the i third units is $n \times i$, and the valid information bits are bits comprising an information amount, the valid information bits are information bits that are encoded by an encoder and actually input to the interleaver, and then are carried on subcarriers;
the second interleaver is configured to perform interleaving mapping on valid information bits of the fourth unit based on the modulation order of the second RU, a quantity of columns of the valid information bits of the fourth unit is less than or equal to the quantity of columns of the first interleaver, and a total quantity of rows of valid information bits of the i fourth units is $m \times i$;
a quantity of rows of the second interleaver corresponding to a first row of information bits of a $c^{th}$ third unit is $(c - 1) \times n + (c - 1) \times m + 1$, and c is a positive integer less than or equal to i; and
a quantity of rows of the second interleaver corresponding to a first row of information bits of a $d^{th}$ fourth unit is $d \times n + (d - 1) \times m + 1$, and d is a positive integer less than or equal to i.

9. The interleaver according to any one of claims 6 to 8, wherein there is only one spatial data stream on the first RU and the second RU, and the second interleaver is connected to a bit parser; and
after being processed by the bit parser, valid information bits output by the second interleaver by column are sequentially output as first information bits in a unit of n bits and second information bits in a unit of m bits, the first information bits are information bits carried on the subcarrier of the first RU, and the second information bits are information bits carried on the subcarrier of the second RU, and the valid information bits are bits comprising an information amount, the valid information bits are information bits that are encoded by an encoder and actually input to the interleaver, and then are carried on subcarriers.

10. The interleaver according to any one of claims 6 to 8, wherein there are at least two spatial data streams on the first RU and the second RU, the interleaver further comprises a third interleaver, and the third interleaver is configured to connect the second interleaver and a bit parser;

the third interleaver is configured to receive valid information bits output by the second interleaver by column, and perform frequency rotation on a spatial data stream other than a first spatial data stream in the at least two spatial data streams, and the first spatial data stream is one of the at least two spatial data streams; and

after being processed by the bit parser, valid information bits output by the third interleaver by column are sequentially output as first information bits in a unit of n bits and second information bits in a unit of m bits, the first information bits are information bits carried on the subcarrier of the first RU, and the second information bits are information bits carried on the subcarrier of the second RU, and the valid information bits are bits comprising an information amount, the valid information bits are information bits that are encoded by an encoder and actually input to the interleaver, and then are carried on subcarriers.

11. An interleaving method supporting unequal modulation, wherein the method is applied to an interleaver, the interleaver comprises a first interleaver and a second interleaver, the interleaver is configured to interleave information bits, to determine an order of information bits carried in a subcarrier of a first resource unit, RU, and a subcarrier of a second RU, a modulation scheme of the first RU is different from a modulation scheme of the second RU, and the method comprises:

inputting, by the first interleaver, information bits by row (S101), wherein a quantity of columns of the first interleaver is $M_1+M_2$, a quantity of rows of the first interleaver is a larger value in $N_1$ and $N_2$, $N_1$ is a quantity of rows determined based on a quantity of subcarriers of the first RU, $M_1$ is a quantity of columns determined based on the quantity of subcarriers of the first RU, $N_2$ is a quantity of rows determined based on a quantity of subcarriers of the second RU, $M_2$ is a quantity of columns determined based on the quantity of subcarriers of the second RU, and $N_1$, $M_1$, $N_2$, and $M_2$ are positive integers; wherein $N_1 = x \cdot N_{BPSCS,1}$ and $x \cdot M_1 = N_{SD,1}$, $N_{BPSCS,1}$ is a modulation order of the first RU, $N_{SD,1}$ is a quantity of data subcarriers of the first RU; $N_2 = x \cdot N_{BPSCS,2}$ and $x \cdot M_2 = N_{SD,2}$, $N_{BPSCS,2}$ is a modulation order of the second RU, $N_{SD,2}$ is a quantity of data subcarriers of the second RU, $x$ is a positive integer; and

receiving, by the second interleaver, the information bits that are output by the first interleaver by column, and performing interleaving mapping on the information bits received from the first interleaver (S102).

12. An interleaving method supporting unequal modulation, wherein the method is applied to an interleaver, the interleaver comprises a first interleaver and a second interleaver, the interleaver is configured to interleave information bits, to determine an order of information bits carried in a subcarrier of a first resource unit, RU, and a subcarrier of a second RU, a modulation scheme of the first RU is different from a modulation scheme of the second RU, and the method comprises:

inputting, by the first interleaver, information bits by row (S101), wherein a quantity of rows of the first interleaver is $i \times (n + m)$, a quantity of columns of the first interleaver is j/i, i is a positive integer, n is a modulation order of the first RU, m is a modulation order of the second RU, and j is a larger value in a quantity of subcarriers of the first RU and a quantity of subcarriers of the second RU; and

receiving, by the second interleaver, the information bits that are output by the first interleaver by column, and performing interleaving mapping on the information bits received from the first interleaver (S102).

13. A computer-readable storage medium, wherein the computer-readable storage medium is configured to store instructions, and when the instructions are executed by a computer, the method according to claim 11 or 12 is performed.

14. A computer program product comprising instructions which, when the computer program product is executed by a computer, cause the method according to claim 11 or 12 to be performed.

**Patentansprüche**

1. Verschachtler mit Unterstützung ungleicher Modulation, wobei der Verschachtler einen ersten Verschachtler und einen zweiten Verschachtler umfasst, der Verschachtler dazu konfiguriert ist, Informationsbits zu verschachteln, um eine Reihenfolge von Informationsbits zu bestimmen, die in einem Subträger einer ersten Ressourceneinheit, RU, und einem Subträger einer zweiten RU enthalten sind, und sich ein Modulationsschema der ersten RU von einem Modulationsschema der zweiten RU unterscheidet;

der erste Verschachtler dazu konfiguriert ist, Informationsbits zeilenweise einzugeben, die Spaltenanzahl des ersten Verschachtlers $M_1 + M_2$ ist, die Zeilenanzahl des ersten Verschachtlers der größere Wert von $N_1$ und $N_2$ ist, $N_1$ eine Zeilenanzahl ist, die basierend auf einer Subträgeranzahl der ersten RU bestimmt wird, $M_1$ eine Spaltenanzahl ist, die basierend auf der Subträgeranzahl der ersten RU bestimmt wird, $N_2$ eine Zeilenanzahl ist, die basierend auf einer Subträgeranzahl der zweiten RU bestimmt wird, $M_2$ eine Spaltenanzahl ist, die basierend auf der Subträgeranzahl der zweiten RU bestimmt wird, $N_1$, $M_1$, $N_2$ und $M_2$ positive ganze Zahlen sind; wobei $N_1 = x \cdot N_{BPSCS,1}$ und $x \cdot M_1 = N_{SD,1}$, $N_{BPSCS,1}$ eine Modulationsreihenfolge der ersten RU ist, $N_{SD,1}$ eine Anzahl von Datensubträgern der ersten RU ist; $N_2 = x \cdot N_{BPSCS,2}$ und $x \cdot M_2 = N_{SD,2}$, $N_{BPSCS,2}$ eine Modulationsreihenfolge der zweiten RU ist, $N_{SD,2}$ eine Anzahl von Datensubträgern der zweiten RU ist, $x$ eine positive ganze Zahl ist; und
der zweite Verschachtler dazu konfiguriert ist, die durch den ersten Verschachtler spaltenweise ausgegebenen Informationsbits zu empfangen und eine Verschachtelungsabbildung auf den von dem ersten Verschachtler empfangenen Informationsbits durchzuführen.

2. Verschachtler nach Anspruch 1, wobei der erste Verschachtler dazu konfiguriert ist, Informationsbits einer ersten Einheit und Informationsbits einer zweiten Einheit zeilenweise einzugeben; eine Spaltenanzahl gültiger Informations-bits der ersten Einheit $M_1 + M_2$ ist, eine Zeilenanzahl der gültigen Informationsbits der ersten Einheit ein kleinerer Wert in $N_1$ und $N_2$ ist, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind;

eine Spaltenanzahl gültiger Informationsbits der zweiten Einheit $M_1$ oder $M_2$ ist, und eine Zeilenanzahl der gültigen Informationsbits der zweiten Einheit ein Absolutwert einer Differenz zwischen $N_1$ und $N_2$ ist; und eine erste Zeile der Informationsbits der zweiten Einheit eine ($N_2$+1)-te Zeile des ersten Verschachtlers ist, und eine erste Spalte der Informationsbits der zweiten Einheit eine erste Spalte des Verschachtlers ist; oder eine erste Zeile der Informationsbits der zweiten Einheit eine ($N_1$+1)-te Zeile des ersten Verschachtlers ist, und eine erste Spalte der Informationsbits der zweiten Einheit eine ($M_1$+1)-te Spalte des ersten Verschachtlers ist.

3. Verschachtler nach Anspruch 1 oder 2, wobei der zweite Verschachtler dazu konfiguriert ist, eine Verschachtelungsabbildung auf Informationsbits einer dritten Einheit und Informationsbits einer vierten Einheit durchzuführen;

der zweite Verschachtler dazu konfiguriert ist, eine Verschachtelungsabbildung auf gültigen Informationsbits der dritten Einheit basierend auf einer Modulationsreihenfolge der ersten RU durchzuführen, eine Spaltenanzahl der gültigen Informationsbits der dritten Einheit $M_1$ ist, eine Zeilenanzahl der gültigen Informationsbits der dritten Einheit $N_1$ ist, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind;
der zweite Verschachtler dazu konfiguriert ist, eine Verschachtelungsabbildung auf gültigen Informationsbits der vierten Einheit basierend auf einer Modulationsreihenfolge der zweiten RU durchzuführen, eine Spaltenanzahl der gültigen Informationsbits der vierten Einheit $M_2$ ist, und eine Zeilenanzahl der gültigen Informationsbits der vierten Einheit $N_2$ ist; und
eine erste Spalte der Informationsbits der vierten Einheit eine ($M_1$+1)-te Spalte des zweiten Verschachtlers ist.

4. Verschachtler nach einem der Ansprüche 1 bis 3, wobei sich jeweils nur ein räumlicher Datenstrom auf der ersten RU und der zweiten RU befindet, der zweite Verschachtler mit einem Bit-Parser verbunden ist, durch den zweiten Verschachtler spaltenweise ausgegebene gültige Informationsbits nach dem Verarbeiten durch den Bit-Parser auf dem Subträger der ersten RU und der zweiten RU enthalten sind, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind.

5. Verschachtler nach einem der Ansprüche 1 bis 3, wobei sich mindestens zwei räumliche Datenströme auf der ersten RU und der zweiten RU befinden, der Verschachtler ferner einen dritten Verschachtler umfasst, und der dritte Verschachtler mit dem zweiten Verschachtler und einem Bit-Parser verbunden ist;

der dritte Verschachtler dazu konfiguriert ist, die durch den zweiten Verschachtler spaltenweise ausgegebenen gültigen Informationsbits zu empfangen und eine Frequenzrotation an einem räumlichen Datenstrom durchzuführen, der sich von einem ersten räumlichen Datenstrom unter den mindestens zwei räumlichen Datenströmen unterscheidet, der erste räumliche Datenstrom einer der mindestens zwei räumlichen Datenströme ist, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind; und

gültige Informationsbits, die durch den dritten Verschachtler spaltenweise ausgegeben werden, nach dem Verarbeiten durch den Bit-Parser auf dem Subträger der ersten RU und dem Subträger der zweiten RU enthalten sind.

6. Verschachtler mit Unterstützung ungleicher Modulation, wobei der Verschachtler einen ersten Verschachtler und einen zweiten Verschachtler umfasst, der Verschachtler dazu konfiguriert ist, Informationsbits zu verschachteln, um eine Reihenfolge von Informationsbits zu bestimmen, die in einem Subträger einer ersten Ressourceneinheit, RU, und einem Subträger einer zweiten RU enthalten sind, und sich ein Modulationsschema der ersten RU von einem Modulationsschema der zweiten RU unterscheidet;

der erste Verschachtler dazu konfiguriert ist, Informationsbits zeilenweise einzugeben, eine Zeilenanzahl des ersten Verschachtlers i × (n + m) ist, eine Spaltenanzahl des ersten Verschachtlers j/i ist, i eine positive ganze Zahl ist, n eine Modulationsreihenfolge der ersten RU ist, m eine Modulationsreihenfolge der zweiten RU ist und j der größere Wert einer Subträgeranzahl der ersten RU und einer Subträgeranzahl der zweiten RU ist; und
der zweite Verschachtler dazu konfiguriert ist, die durch den ersten Verschachtler spaltenweise ausgegebenen Informationsbits zu empfangen und eine Verschachtelungsabbildung auf den von dem ersten Verschachtler empfangenen Informationsbits durchzuführen.

7. Verschachtler nach Anspruch 6, wobei der erste Verschachtler dazu konfiguriert ist, Informationsbits von i ersten Einheiten und Informationsbits von i zweiten Einheiten zeilenweise einzugeben;

eine Spaltenanzahl gültiger Informationsbits der ersten Einheit kleiner oder gleich der Spaltenanzahl des ersten Verschachtlers ist, eine Gesamtzeilenanzahl gültiger Informationsbits der i ersten Einheiten n × i ist, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind;
eine Spaltenanzahl gültiger Informationsbits der zweiten Einheit kleiner oder gleich der Spaltenanzahl des ersten Verschachtlers ist, und eine Gesamtzeilenanzahl gültiger Informationsbits der i zweiten Einheiten m × i ist;
eine Zeilenanzahl des ersten Verschachtlers entsprechend einer ersten Zeile von Informationsbits einer a-ten ersten Einheit (a - 1) × n + (a - 1) × m + 1 ist, und a eine positive ganze Zahl kleiner oder gleich i ist; und
eine Zeilenanzahl des ersten Verschachtlers entsprechend einer ersten Zeile von Informationsbits einer b-ten zweiten Einheit b × n + (b - 1) × m + 1 ist, und b eine positive ganze Zahl kleiner oder gleich i ist.

8. Verschachtler nach Anspruch 6 oder 7, wobei der zweite Verschachtler dazu konfiguriert ist, eine Verschachtelungsabbildung auf Informationsbits von i dritten Einheiten und Informationsbits von i vierten Einheiten durchzuführen;

der zweite Verschachtler dazu konfiguriert ist, eine Verschachtelungsabbildung auf gültigen Informationsbits der dritten Einheit basierend auf der Modulationsreihenfolge der ersten RU durchzuführen, eine Spaltenanzahl der gültigen Informationsbits der dritten Einheit kleiner oder gleich der Spaltenanzahl des ersten Verschachtlers ist, eine Gesamtzeilenanzahl gültiger Informationsbits der i dritten Einheiten n × i ist, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind;
der zweite Verschachtler dazu konfiguriert ist, eine Verschachtelungsabbildung auf gültigen Informationsbits der vierten Einheit basierend auf der Modulationsreihenfolge der zweiten RU durchzuführen, eine Spaltenanzahl der gültigen Informationsbits der vierten Einheit kleiner oder gleich der Spaltenanzahl des ersten Verschachtlers ist, und eine Gesamtzeilenanzahl gültiger Informationsbits der i vierten Einheiten m × i ist;
eine Zeilenanzahl des ersten Verschachtlers entsprechend einer ersten Zeile von Informationsbits einer c-ten dritten Einheit (c - 1) × n + (c - 1) × m + 1 ist, und c eine positive ganze Zahl kleiner oder gleich i ist; und
eine Zeilenanzahl des zweiten Verschachtlers entsprechend einer ersten Zeile von Informationsbits einer d-ten vierten Einheit d × n + (d - 1) × m + 1 ist, und d eine positive ganze Zahl kleiner oder gleich i ist.

9. Verschachtler nach einem der Ansprüche 6 bis 8, wobei nur ein räumlicher Datenstrom auf der ersten RU und der zweiten RU vorliegt, und der zweite Verschachtler mit einem Bit-Parser verbunden ist; und

gültige Informationsbits, die spaltenweise durch den zweiten Verschachtler ausgegeben werden, nach dem Verarbeiten durch den Bit-Parser sequenziell als erste Informationsbits in einer Einheit von n Bits und zweite Informationsbits in einer Einheit von m Bits ausgegeben werden, die ersten Informationsbits Informationsbits sind, die auf dem Subträger der ersten RU enthalten sind, und die zweiten Informationsbits Informationsbits sind, die auf dem Subträger der zweiten RU enthalten sind, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind.

10. Verschachtler nach einem der Ansprüche 6 bis 8, wobei sich mindestens zwei räumliche Datenströme auf der ersten RU und der zweiten RU befinden, der Verschachtler ferner einen dritten Verschachtler umfasst, und der dritte Verschachtler dazu konfiguriert ist, den zweiten Verschachtler und einen Bit-Parser zu verbinden;

der dritte Verschachtler dazu konfiguriert ist, gültige Informationsbits, die spaltenweise durch den zweiten Verschachtler ausgegeben werden, zu empfangen und eine Frequenzrotation an einem räumlichen Datenstrom durchzuführen, der sich von dem ersten räumlichen Datenstrom in den mindestens zwei räumlichen Datenströmen unterscheidet, und der erste räumliche Datenstrom einer der mindestens zwei räumlichen Datenströme ist; und

gültige Informationsbits, die spaltenweise durch den dritten Verschachtler ausgegeben werden, nach dem Verarbeiten durch den Bit-Parser sequenziell als erste Informationsbits in einer Einheit von n Bits und zweite Informationsbits in einer Einheit von m Bits ausgegeben werden, die ersten Informationsbits Informationsbits sind, die auf dem Subträger der ersten RU enthalten sind, und die zweiten Informationsbits Informationsbits sind, die auf dem Subträger der zweiten RU enthalten sind, und die gültigen Informationsbits Bits sind, die eine Informationsmenge umfassen, die gültigen Informationsbits Informationsbits sind, die durch einen Codierer codiert werden und tatsächlich in den Verschachtler eingegeben werden und danach auf Subträgern enthalten sind.

11. Verschachtelungsverfahren mit Unterstützung ungleicher Modulation, wobei das Verfahren auf einen Verschachtler angewendet wird, der Verschachtler einen ersten Verschachtler und einen zweiten Verschachtler umfasst, der Verschachtler dazu konfiguriert ist, Informationsbits zu verschachteln, um eine Reihenfolge von Informationsbits zu bestimmen, die in einem Subträger einer ersten Ressourceneinheit, RU, und einem Subträger einer zweiten RU enthalten sind, sich ein Modulationsschema der ersten RU von einem Modulationsschema der zweiten RU unterscheidet, und das Verfahren Folgendes umfasst:

zeilenweises Eingeben (S101) von Informationsbits durch den ersten Verschachtler, wobei eine Spaltenanzahl des ersten Verschachtlers $M_1 + M_2$ ist, eine Zeilenanzahl des ersten Verschachtlers ein größerer Wert von $N_1$ und $N_2$ ist, $N_1$ eine Zeilenanzahl ist, die basierend auf einer Subträgeranzahl der ersten RU bestimmt wird, $M_1$ eine Spaltenanzahl ist, die basierend auf der Subträgeranzahl der ersten RU bestimmt wird, $N_2$ eine Zeilenanzahl ist, die basierend auf einer Subträgeranzahl der zweiten RU bestimmt wird, $M_2$ eine Spaltenanzahl ist, die basierend auf der Subträgeranzahl der zweiten RU bestimmt wird, $N_1, M_1, N_2$ und $M_2$ positive ganze Zahlen sind; wobei $N_1 = x \cdot N_{BPSCS,1}$ und $x \cdot M_1 = N_{SD,1}$, $N_{BPSCS,1}$ eine Modulationsreihenfolge der ersten RU ist, $N_{SD,1}$ eine Anzahl von Datensubträgern der ersten RU ist;

$N_2 = x \cdot N_{BPSCS,2}$ und $x \cdot M_2 = N_{SD,2}$, $N_{BPSCS,2}$ eine Modulationsreihenfolge der zweiten RU ist, $N_{SD,2}$ eine Anzahl von Datensubträgern der zweiten RU ist, $x$ eine positive ganze Zahl ist; und

Empfangen der durch den ersten Verschachtler spaltenweise ausgegebenen Informationsbits durch den zweiten Verschachtler und Durchführen einer Verschachtelungsabbildung auf den von dem ersten Verschachtler (S102) empfangenen Informationsbits.

12. Verschachtelungsverfahren mit Unterstützung ungleicher Modulation, wobei das Verfahren auf einen Verschachtler angewendet wird, der Verschachtler einen ersten Verschachtler und einen zweiten Verschachtler umfasst, der Verschachtler dazu konfiguriert ist, Informationsbits zu verschachteln, um eine Reihenfolge von Informationsbits zu bestimmen, die in einem Subträger einer ersten Ressourceneinheit, RU, und einem Subträger einer zweiten RU enthalten sind, sich ein Modulationsschema der ersten RU von einem Modulationsschema der zweiten RU unterscheidet, und das Verfahren Folgendes umfasst:

zeilenweises Eingeben (S101) von Informationsbits durch den ersten Verschachtler, wobei eine Zeilenanzahl des ersten Verschachtlers $i \times (n + m)$ ist, eine Spaltenanzahl des ersten Verschachtlers $j/i$ ist, wobei i eine positive ganze Zahl ist, n die Modulationsreihenfolge der ersten RU ist, m die Modulationsreihenfolge der zweiten RU ist und j der größere Wert einer Subträgeranzahl der ersten RU und einer Subträgeranzahl der zweiten RU ist; und Empfangen der durch den ersten Verschachtler spaltenweise ausgegebenen Informationsbits durch den zweiten Verschachtler und Durchführen einer Verschachtelungsabbildung auf den von dem ersten Verschachtler (S102) empfangenen Informationsbits.

13. Computerlesbares Speichermedium, wobei das computerlesbare Speichermedium dazu konfiguriert ist, Anweisungen zu speichern, und bei Ausführung der Anweisungen durch einen Computer das Verfahren nach Anspruch 11 oder 12 durchgeführt wird.

14. Computerprogrammprodukt, umfassend Anweisungen, welche bei Ausführung des Computerprogrammprodukts durch einen Computer bewirken, dass das Verfahren nach Anspruch 11 oder 12 durchzuführen ist.

## Revendications

1. Entrelaceur prenant en charge une modulation inégale, dans lequel l'entrelaceur comprend un premier entrelaceur et un deuxième entrelaceur, l'entrelaceur est configuré pour entrelacer des bits d'information, afin de déterminer un ordre de bits d'information transportés dans une sous-porteuse d'une première unité de ressource, RU, et une sous-porteuse d'une seconde RU, et un schéma de modulation de la première RU est différent d'un schéma de modulation de la seconde RU ;

le premier entrelaceur est configuré pour entrer des bits d'information par ligne, une quantité de colonnes du premier entrelaceur est $M_1+M_2$, une quantité de lignes du premier entrelaceur est une valeur plus grande dans $N_1$ et $N_2$, $N_1$ est une quantité de lignes déterminée sur la base d'une quantité de sous-porteuses de la première RU, $M_1$ est une quantité de colonnes déterminée sur la base de la quantité de sous-porteuses de la première RU, $N_2$ est une quantité de lignes déterminée sur la base d'une quantité de sous-porteuses de la seconde RU, $M_2$ est une quantité de colonnes déterminée sur la base de la quantité de sous-porteuses de la seconde RU , et $N_1$, $M_1$, $N_2$, et $M_2$ sont des entiers positifs ;

dans lequel $N_1 = x \cdot N_{BPSCS,1}$ et $x \cdot M_1 = N_{SD,1}$, $N_{BPSCS,1}$ est un ordre de modulation de la première RU, $N_{SD,1}$ est une quantité de sous-porteuses de données de la première RU ; $N_2 = x \cdot N_{BPSCS,2}$ et $x \cdot M_2 = N_{SD,2}$, $N_{BPSCS,2}$ est un ordre de modulation de la seconde RU, $N_{SD,2}$ est une quantité de sous-porteuses de données de la seconde RU, x est un entier positif ; et

le deuxième entrelaceur est configuré pour recevoir les bits d'information produits par le premier entrelaceur par colonne, et réaliser une mise en correspondance d'entrelacement sur les bits d'information reçus du premier entrelaceur.

2. Entrelaceur selon la revendication 1, dans lequel le premier entrelaceur est configuré pour entrer des bits d'information d'une première unité et des bits d'information d'une deuxième unité par ligne ;

une quantité de colonnes de bits d'information valides de la première unité est $M_1+M_2$, une quantité de lignes de bits d'information valides de la première unité est une valeur plus petite dans $N_1$ et $N_2$, et les bits d'information valides sont des bits comprenant une quantité d'information, les bits d'information valides sont des bits d'information qui sont encodés par un encodeur et effectivement entrés dans l'entrelaceur, puis transportés sur des sous-porteuses ;

une quantité de colonnes de bits d'information valides de la deuxième unité est $M_1$ ou $M_2$, et une quantité de lignes des bits d'information valides de la deuxième unité est une valeur absolue d'une différence entre $N_1$ et $N_2$ ; et une première ligne des bits d'information de la deuxième unité est une $(N_2+1)^{ème}$ ligne du premier entrelaceur, et une première colonne des bits d'information de la deuxième unité est une première colonne de l'entrelaceur ; ou une première ligne des bits d'information de la deuxième unité est une $(N_1+1)^{ème}$ ligne du premier entrelaceur, et une première colonne des bits d'information de la deuxième unité est une $(M_1+1)^{ème}$ colonne du premier entrelaceur.

3. Entrelaceur selon la revendication 1 ou 2, dans lequel le deuxième entrelaceur est configuré pour réaliser une mise en correspondance d'entrelacement sur des bits d'information d'une troisième unité et des bits d'information d'une quatrième unité ;

le deuxième entrelaceur est configuré pour réaliser une mise en correspondance d'entrelacement sur des bits d'information valides de la troisième unité sur la base d'un ordre de modulation de la première RU, une quantité de colonnes des bits d'information valides de la troisième unité est $M_1$, une quantité de lignes des bits d'information valides de la troisième unité est $N_1$, et les bits d'information valides sont des bits comprenant une quantité d'information, les bits d'information valides sont des bits d'information qui sont encodés par un encodeur et effectivement entrés dans l'entrelaceur, puis transportés sur des sous-porteuses ;

le deuxième entrelaceur est configuré pour réaliser une mise en correspondance d'entrelacement sur des bits d'information valides de la quatrième unité sur la base d'un ordre de modulation de la seconde RU, une quantité de colonnes des bits d'information valides de la quatrième unité est $M_2$, et une quantité de lignes des bits d'information valides de la quatrième unité est $N_2$ ; et une première colonne des bits d'information de la quatrième unité est une $(M_1+1)^{\text{ème}}$ colonne du deuxième entrelaceur.

4. Entrelaceur selon l'une quelconque des revendications 1 à 3, dans lequel il n'y a qu'un seul flux de données spatiales sur la première RU et la seconde RU, le deuxième entrelaceur est connecté à un analyseur de bits, après avoir été traités par l'analyseur de bits, des bits d'information valides produits par le deuxième entrelaceur par colonne sont transportés sur la sous-porteuse de la première RU et la sous-porteuse de la seconde RU, et les bits d'information valides sont des bits comprenant une quantité d'information, les bits d'information valides sont des bits d'information encodés par un encodeur et effectivement entrés dans l'entrelaceur, puis transportés sur des sous-porteuses.

5. Entrelaceur selon l'une quelconque des revendications 1 à 3, dans lequel il existe au moins deux flux de données spatiales sur la première RU et la seconde RU, l'entrelaceur comprend également un troisième entrelaceur, et le troisième entrelaceur est connecté au deuxième entrelaceur et à un analyseur de bits ; le troisième entrelaceur est configuré pour recevoir des bits d'information valides produits par le deuxième entrelaceur par colonne et réaliser une rotation de fréquence sur un flux de données spatiales autre qu'un premier flux de données spatiales dans les au moins deux flux de données spatiales, le premier flux de données spatiales est l'un des au moins deux flux de données spatiales, et les bits d'information valides sont des bits comprenant une quantité d'information, les bits d'information valides sont des bits d'information encodés par un encodeur et effectivement entrés dans l'entrelaceur, puis transportés sur des sous-porteuses ; et

après avoir été traités par l'analyseur de bits, des bits d'information valides produits par le troisième entrelaceur par colonne sont transportés sur la sous-porteuse de la première RU et la sous-porteuse de la seconde RU.

6. Entrelaceur prenant en charge une modulation inégale, dans lequel l'entrelaceur comprend un premier entrelaceur et un deuxième entrelaceur, l'entrelaceur est configuré pour entrelacer des bits d'information, afin de déterminer un ordre de bits d'information transportés dans une sous-porteuse d'une première unité de ressource, RU, et une sous-porteuse d'une seconde RU, et un schéma de modulation de la première RU est différent d'un schéma de modulation de la seconde RU ;

le premier entrelaceur est configuré pour entrer des bits d'information par ligne, une quantité de lignes du premier entrelaceur est $i \times (n + m)$, une quantité de colonnes du premier entrelaceur est $j/i$, i est un entier positif, n est un ordre de modulation de la première RU, m est un ordre de modulation de la seconde RU, et j est la plus grande valeur dans une quantité de sous-porteuses de la première RU et une quantité de sous-porteuses de la seconde RU ; et

le deuxième entrelaceur est configuré pour recevoir les bits d'information produits par le premier entrelaceur par colonne, et réaliser une mise en correspondance d'entrelacement sur les bits d'information reçus du premier entrelaceur.

7. Entrelaceur selon la revendication 6, dans lequel le premier entrelaceur est configuré pour entrer des bits d'information de i premières unités et des bits d'information de i deuxièmes unités par ligne ;

une quantité de colonnes de bits d'information valides de la première unité est inférieure ou égale à la quantité de colonnes du premier entrelaceur, une quantité totale de lignes de bits d'information valides des i premières unités $n \times i$, et les bits d'information valides sont des bits comprenant une quantité d'information, les bits d'information valides sont des bits d'information qui sont encodés par un encodeur et effectivement entrés dans l'entrelaceur, puis transportés sur des sous-porteuses ;

une quantité de colonnes de bits d'information valides de la deuxième unité est inférieure ou égale à la quantité de colonnes du premier entrelaceur, et une quantité totale de lignes de bits d'information valides des i deuxièmes unités est $m \times i$ ;

une quantité de lignes du premier entrelaceur correspondant à une première ligne de bits d'information d'une $a^{\text{ème}}$ première unité a est $(a - 1) \times n + (a - 1) \times m + 1$, et a est un entier positif inférieur ou égal à i ; et

une quantité de lignes du premier entrelaceur correspondant à une première ligne de bits d'information d'une $b^{ème}$ deuxième unité a est $b \times n + (b - 1) \times m + 1$, et b est un entier positif inférieur ou égal à i.

8. Entrelaceur selon la revendication 6 ou 7, dans lequel le deuxième entrelaceur est configuré pour réaliser une mise en correspondance d'entrelacement sur des bits d'information de i troisièmes unités et des bits d'information de i quatrièmes unités ;

   le deuxième entrelaceur est configuré pour réaliser une mise en correspondance d'entrelacement sur des bits d'information valides de la troisième unité sur la base de l'ordre de modulation de la première RU, une quantité de colonnes des bits d'information valides de la troisième unité est inférieure ou égale à la quantité de colonnes du premier entrelaceur, une quantité totale de lignes de bits d'information valides des i troisièmes unités est $n \times i$, et les bits d'information valides sont des bits comprenant une quantité d'information, les bits d'information valides sont des bits d'information qui sont encodés par un encodeur et effectivement entrés dans l'entrelaceur, puis transportés sur des sous-porteuses ;
   le deuxième entrelaceur est configuré pour réaliser une mise en correspondance d'entrelacement sur des bits d'information valides de la quatrième unité sur la base de l'ordre de modulation de la seconde RU, une quantité de colonnes des bits d'information valides de la quatrième unité est inférieure ou égale à la quantité de colonnes du premier entrelaceur, et une quantité totale de lignes de bits d'information valides des i quatrièmes unités est $m \times i$ ;
   une quantité de lignes du deuxième entrelaceur correspondant à une première ligne de bits d'information d'une $c^{ème}$ troisième unité a est $(c - 1) \times n + (c - 1) \times m + 1$, et c est un entier positif inférieur ou égal à i ; et
   une quantité de lignes du deuxième entrelaceur correspondant à une première ligne de bits d'information d'une $d^{ème}$ quatrième unité a est $d \times n + (d - 1) \times m + 1$, et d est un entier positif inférieur ou égal à i.

9. Entrelaceur selon l'une quelconque des revendications 6 à 8, dans lequel il n'y a qu'un seul flux de données spatiales sur la première RU et la seconde RU, et le deuxième entrelaceur est connecté à un analyseur de bits ; et
   après avoir été traités par l'analyseur de bits, des bits d'information valides produits par le deuxième entrelaceur par colonne sont produits séquentiellement sous forme de premiers bits d'information dans une unité de n bits et de seconds bits d'information dans une unité de m bits, les premiers bits d'information sont des bits d'information transportés sur la sous-porteuse de la première RU, et les seconds bits d'information sont des bits d'information transportés sur la sous-porteuse de la seconde RU, et les bits d'information valides sont des bits comprenant une quantité d'information, les bits d'information valides sont des bits d'information encodés par un encodeur et effectivement entrés dans l'entrelaceur, puis transportés sur des sous-porteuses.

10. Entrelaceur selon l'une quelconque des revendications 6 à 8, dans lequel il existe au moins deux flux de données spatiales sur la première RU et la seconde RU, l'entrelaceur comprend également un troisième entrelaceur, et le troisième entrelaceur est configuré pour se connecter au deuxième entrelaceur et à un analyseur de bits ;

    le troisième entrelaceur est configuré pour recevoir des bits d'information valides produits par le deuxième entrelaceur par colonne, et réaliser une rotation de fréquence sur un flux de données spatiales autre qu'un premier flux de données spatiales dans les au moins deux flux de données spatiales, et le premier flux de données spatiales est l'un des au moins deux flux de données spatiales ; et
    après avoir été traités par l'analyseur de bits, des bits d'information valides produits par le troisième entrelaceur par colonne sont produits séquentiellement sous forme de premiers bits d'information dans une unité de n bits et de seconds bits d'information dans une unité de m bits, les premiers bits d'information sont des bits d'information transportés sur la sous-porteuse de la première RU, et les seconds bits d'information sont des bits d'information transportés sur la sous-porteuse de la seconde RU, et les bits d'information valides sont des bits comprenant une quantité d'information, les bits d'information valides sont des bits d'information encodés par un encodeur et effectivement entrés dans l'entrelaceur, puis transportés sur des sous-porteuses.

11. Procédé d'entrelacement prenant en charge une modulation inégale, dans lequel le procédé est appliqué à un entrelaceur, l'entrelaceur comprend un premier entrelaceur et un deuxième entrelaceur, l'entrelaceur est configuré pour entrelacer des bits d'information, afin de déterminer un ordre de bits d'information transportés dans une sous-porteuse d'une première unité de ressource, RU, et une sous-porteuse d'une seconde RU, un schéma de modulation de la première RU est différent d'un schéma de modulation de la seconde RU, et le procédé comprend :

    l'entrée, par le premier entrelaceur, de bits d'information par ligne (S101), dans lequel une quantité de colonnes du premier entrelaceur est $M_1+M_2$, une quantité de lignes du premier entrelaceur est une valeur plus grande dans $N_1$ et $N_2$, $N_1$ est une quantité de lignes déterminée sur la base d'une quantité de sous-porteuses de la première

RU, $M_1$ est une quantité de colonnes déterminée sur la base de la quantité de sous-porteuses de la première RU, $N_2$ est une quantité de lignes déterminée sur la base d'une quantité de sous-porteuses de la seconde RU, $M_2$ est une quantité de colonnes déterminée sur la base de la quantité de sous-porteuses de la seconde RU , et $N_1$, $M_1$, $N_2$, et $M_2$ sont des entiers positifs ; dans lequel $N_1 = x \cdot N_{BPSCS,1}$ et $x \cdot M_1 = N_{SD,1}$, $N_{BPSCS,1}$ est un ordre de modulation de la première RU, $N_{SD,1}$ est une quantité de sous-porteuses de données de la première RU ; $N_2 = x \cdot N_{BPSCS,2}$ et $x \cdot M_2 = N_{SD,2}$, $N_{BPSCS,2}$ est un ordre de modulation de la seconde RU, $N_{SD,2}$ est une quantité de sous-porteuses de données de la seconde RU, $x$ est un entier positif ; et

la réception, par le deuxième entrelaceur, des bits d'information produits par le premier entrelaceur par colonne, et la réalisation d'une mise en correspondance d'entrelacement sur les bits d'information reçus du premier entrelaceur (S102).

12. Procédé d'entrelacement prenant en charge une modulation inégale, dans lequel le procédé est appliqué à un entrelaceur, l'entrelaceur comprend un premier entrelaceur et un deuxième entrelaceur, l'entrelaceur est configuré pour entrelacer des bits d'information, afin de déterminer un ordre de bits d'information transportés dans une sous-porteuse d'une première unité de ressource, RU, et une sous-porteuse d'une seconde RU, un schéma de modulation de la première RU est différent d'un schéma de modulation de la seconde RU, et le procédé comprend :

l'entrée, par le premier entrelaceur, de bits d'information par ligne (S101), dans lequel une quantité de lignes du premier entrelaceur est $i \times (n + m)$, une quantité de colonnes du premier entrelaceur est $j/i$, $i$ est un entier positif, $n$ est un ordre de modulation de la première RU, $m$ est un ordre de modulation de la seconde RU, et $j$ est la plus grande valeur dans une quantité de sous-porteuses de la première RU et une quantité de sous-porteuses de la seconde RU ; et

la réception, par le deuxième entrelaceur, des bits d'information produits par le premier entrelaceur par colonne, et la réalisation d'une mise en correspondance d'entrelacement sur les bits d'information reçus du premier entrelaceur (S102).

13. Support de stockage lisible par ordinateur, dans lequel le support de stockage lisible par ordinateur est configuré pour stocker des instructions, et lorsque les instructions sont exécutées par un ordinateur, le procédé selon la revendication 11 ou 12 est réalisé.

14. Produit de programme informatique comprenant des instructions qui, lorsque le programme informatique est exécuté par un ordinateur, amènent le procédé selon la revendication 11 ou 12 à être réalisé.

FIG. 1

Tone: subcarrier
RU: resource unit
Guard: guard subcarrier
DC: direct current subcarrier

FIG. 2A

Tone: subcarrier
RU: resource unit
Guard: guard subcarrier
DC: direct current subcarrier

FIG. 2B

EP 4 152 710 B1

FIG. 2C

FIG. 3

FIG. 4

Before interleaving

After interleaving

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

First unit

Second unit

LDPC tone mapper

FIG. 19

Third unit

Fourth unit

LDPC tone mapper

FIG. 20

S101: A first interleaver inputs information bits by row

S102: A second interleaver receives the information bits that are output by the first interleaver by column, and performs interleaving mapping on the information bits

FIG. 21

S201: A first unit maps a subcarrier of a first RU and a subcarrier of a second RU based on a modulation scheme of the first RU

S202: A second unit maps a subcarrier of a third RU based on a modulation scheme of the third RU

FIG. 22

**EP 4 152 710 B1**

**REFERENCES CITED IN THE DESCRIPTION**

**Patent documents cited in the description**

- US 10536196 B2
- CN 106922212 B
- US 8605664 B2